(19)

Europäisches
Patentamt
European
Patent Office
Office européen
des brevets

(11) **EP 4 513 796 A1**

(12) **EUROPEAN PATENT APPLICATION**
published in accordance with Art. 153(4) EPC

(43) Date of publication:
26.02.2025 Bulletin 2025/09

(21) Application number: 23810764.3

(22) Date of filing: 28.04.2023

(51) International Patent Classification (IPC):
*H04L 1/00* *(2006.01)*

(52) Cooperative Patent Classification (CPC):
**H04L 1/00**

(86) International application number:
**PCT/CN2023/091496**

(87) International publication number:
**WO 2023/226691 (30.11.2023 Gazette 2023/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 24.05.2022 CN 202210574966

(71) Applicant: **Huawei Technologies Co., Ltd.
Shenzhen, Guangdong 518129 (CN)**

(72) Inventors:
• **QIN, Kangjian
Shenzhen, Guangdong 518129 (CN)**

• **ZHANG, Huazi
Shenzhen, Guangdong 518129 (CN)**
• **WANG, Xianbin
Shenzhen, Guangdong 518129 (CN)**
• **BI, Xiaoyan
Shenzhen, Guangdong 518129 (CN)**
• **LI, Rong
Shenzhen, Guangdong 518129 (CN)**
• **WANG, Jun
Shenzhen, Guangdong 518129 (CN)**

(74) Representative: **Gill Jennings & Every LLP
The Broadgate Tower
20 Primrose Street
London EC2A 2ES (GB)**

(54) **COMMUNICATION METHOD AND COMMUNICATION APPARATUS**

(57)     A communication method and a communication apparatus are provided. The method includes: a first device first checks a first bit sequence based on a CRC code, to obtain a second bit sequence; then divides the second bit sequence into P bit sequences; and generates Q codewords based on the P bit sequences, and sends the Q codewords to a second device through P transport layers. P represents a quantity of transport layers of the first device, P is greater than or equal to 2, and Q is an integer greater than or equal to 2. The first device first checks the first bit sequence based on the CRC code, and then divides the second bit sequence into the P bit sequences, that is, performs code rate allocation. In other words, data at different transport layers is coupled by using the CRC, allowing the data at the different transport layers to be associated. Therefore, in a decoding process, a receive end may decode a latter transport layer by using a decoding result of a former transport layer, to increase a decoding gain of the receive end.

FIG. 4

EP 4 513 796 A1

**Description**

**CROSS-REFERENCE TO RELATED APPLICATIONS**

This application claims priority to Chinese Patent Application No. 202210574966.0, filed with the China National Intellectual Property Administration on May 24, 2022 and entitled "COMMUNICATION METHOD AND COMMUNICATION APPARATUS", which is incorporated herein by reference in its entirety.

**TECHNICAL FIELD**

This application relates to the field of communication technologies, and in particular, to a communication method and a communication apparatus.

**BACKGROUND**

To improve a system throughput, a multiple-input and multiple-output (multiple-input and multiple-output, MIMO) technology is introduced. The MIMO technology refers to the use of a plurality of transmit antennas and a plurality of receive antennas respectively at a transmit end and a receive end. That is, there are a plurality of independent channels between the transmit end and the receive end. In other words, there is sufficient spacing between antenna elements. Therefore, the MIMO technology can eliminate inter-line signal correlation, improve signal link performance, and increase a data throughput.

In a new radio (new radio, NR) system, a main processing procedure of transmitting data at a physical layer based on the MIMO technology is as follows: A MAC layer sends, to the physical layer, the data in a form of transport blocks (transport block, TB); and after receiving the TBs, the physical layer processes the TBs into codewords (codeword, CW). Currently, a general procedure of processing TBs into CWs is as follows: A transmit end performs code rate allocation on bit sequences for the TBs based on a quantity of layers of MIMO, then checks, based on a CRC code, a plurality of bit sequences obtained through the code rate allocation, and subsequently performs channel coding, rate matching, and code block concatenation to obtain the CWs. The transmit end maps the CWs to transport layers to send the CWs to a receive end. The receive end sequentially decodes, based on a decoding order of the plurality of CWs, the transport layers to which the CWs are mapped.

Because the transmit end initially performs code rate allocation based on the quantity of transport layers, data transmitted between different transport layers is independent of each other without association. For the receive end, in a decoding process, each transport layer performs decoding separately, and a latter transport layer cannot use a decoding result of a former transport layer. That is, a decoding gain of the receive end is limited.

**SUMMARY**

This application provides a communication method and a communication apparatus, to improve a decoding gain in multi-codeword transmission.

According to a first aspect, an embodiment of this application provides a communication method. The method may be performed by a first device. The first device may be a communication device or a communication apparatus that can support the communication device in implementing functions needed in the method, for example, a chip system. An example in which the communication device is the first device is used below for description. For example, the communication device is the first device, a chip disposed in the first device, or another component configured to implement functions of the first device.

The communication method includes: The first device first checks a first bit sequence based on a cyclic redundancy check (cyclic redundancy check, CRC) code, to obtain a second bit sequence; then divides the second bit sequence into P bit sequences; and generates Q codewords based on the P bit sequences, and sends the Q codewords to a second device through P transport layers. P is a quantity of transport layers of the first device, P is greater than or equal to 2, and Q is an integer greater than or equal to 2. The first bit sequence may also be considered as an original data bit stream. Dividing the second bit sequence into the P bit sequences is a code rate allocation process. The Q codewords are transmitted through the P transport layers. In other words, the P bit sequences are transmitted through the P transport layers. The first device first checks the original bit stream based on the CRC code, and then divides the original bit stream into the P bit sequences, that is, performs code rate allocation. In this way, data at different transport layers (codewords) is coupled by using the CRC, so that the data at the different transport layers (codewords) is associated. For a receive end, in a decoding process, a decoding result of the former transport layer (codeword) may be used to decode the latter transport layer (codeword). For example, the receive end may reserve all decoding results of the former transport layer (codeword), and perform joint decoding for the latter transport layer (codeword) by using the reserved decoding results, so that incorrect transmission can be reduced, and a decoding gain of the receive end can be increased. In addition, the data at the different transport layers (codewords) may be coupled based on one CRC. That is, CRC overheads are reduced.

In a possible implementation, the method further includes: The first device sends a first modulation and coding scheme (modulation and coding scheme, MCS) index to the second device. The first MCS index indicates code rates and modulation orders that respectively correspond to the Q codewords. To be specific, one MCS index may indicate code rates and modulation orders that correspond to a plurality of codewords. For example, one MCS index may correspond to a plurality of groups of code rates and modulation orders, and one group of a code rate and a modulation order corresponds to one codeword. The first device may provide the first MCS index for the second device, so that the second device and the first device have same code rates and same modulation orders that respectively correspond to the Q codewords.

In a possible implementation, that the first MCS index indicates code rates and modulation orders that respectively correspond to the Q codewords includes: The first MCS index corresponds to Q sub-indexes, where the Q sub-indexes are in one-to-one correspondence with the Q codewords, and one of the Q sub-indexes corresponds to one group of a code rate and a modulation order. In an implementation in which the first MCS index indicates the code rates and the modulation orders that respectively correspond to the Q codewords, one MCS index may correspond to a plurality of MCS sub-indexes, and one sub-index corresponds to a code rate and a modulation order of one codeword.

In a possible implementation, the method further includes: The first device receives indication information sent by the second device, where the indication information indicates whether the second device uses a first receiving mode. Different second devices use different receivers, and may correspond to different receiving modes. The first receiving mode may also be understood as a strong processing capability of a receiver used by the second device, or a type of a receiver used by the second device. For example, the second device uses a successive interference cancellation (successive interference cancellation, SIC) receiver. Therefore, the second device may notify the first device whether the second device uses the first receiving mode. Correspondingly, the first device performs code rate allocation and modulation depending on whether the second device uses the first receiving mode, that is, determines the modulation orders and the code rates that respectively correspond to the Q codewords, that is, determines the first MCS index.

In a possible implementation, the method further includes: The first device determines the first MCS index based on the indication information.

In a possible implementation, Q is equal to P, and the Q codewords are one-to-one mapped to the P transport layers; or Q is less than P, and one of the Q codewords is mapped to one or two layers in the P transport layers. That is, one codeword may be mapped to one transport layer, or may be mapped to a plurality of transport layers.

In a possible implementation, that the first device divides the second bit sequence into P bit sequences includes: The first device divides the second bit sequence into the P bit sequences based on a capacity of each of the P transport layers, where transport layers with different capacities correspond to different lengths of bit sequences. The first device performs code rate allocation based on a capacity of each transport layer in the first receiving mode, that is, designs, by using a capacity difference between transport layers, a codeword with a length matching each transport layer, to improve an encoding gain.

In a possible implementation, a capacity of a $k^{th}$ transport layer in the P transport layers is based on transmit power, interference power, and noise power of the $k^{th}$ transport layer.

In a possible implementation, the capacity $C_k$ of the $k^{th}$ transport layer in the P transport layers satisfies the following formula:

$$C_k = \log\left(1 + P_k \boldsymbol{h}_k^* \left(N_0 \boldsymbol{I}_{N_r} + \sum_{i=k+1}^{N_t} P_i \boldsymbol{h}_k \boldsymbol{h}_k^*\right)^{-1} \boldsymbol{h}_k\right),$$

where

k=1, 2, ..., P, $P_k$ is transmit power of each antenna of the first device, $N_0$ is noise power, $\boldsymbol{h_k}$ is a $k^{th}$ column for a channel H, $N_r$ is a quantity of receive antennas, $N_t$ is a quantity of transmit antennas, $\boldsymbol{h_k}$ is the $k^{th}$ column for the channel H, and $\boldsymbol{h}_k^*$ is a conjugate transpose of $h_k$.

According to a second aspect, an embodiment of this application provides a communication method. The method may be performed by a second device. The second device may be a communication device or a communication apparatus that can support the communication device in implementing functions needed in the method, for example, a chip system. An example in which the communication device is the second device is used below for description. For example, the communication device is the second device, a chip disposed in the second device, or another component configured to implement functions of the second device.

The communication method includes: The second device receives, from P transport layers, Q codewords sent by a first device, and receives a first MCS index sent by the first device. P is an integer greater than or equal to 2, Q is an integer greater than or equal to 2, and the first MCS index indicates code rates and modulation orders that respectively correspond to the Q codewords. The second device may be understood as a receive end. The first device may provide the first MCS index for the second device, and the first MCS index may indicate the code rates and the modulation orders that respectively correspond to the Q codewords, so that the second device decodes the Q codewords based on the first MCS index. The first MCS index may indicate the code rates and the modulation orders that respectively correspond to the Q codewords. To be specific, the first device needs to send signaling only once, to provide, for the second device, the code rates and the modulation orders that respectively correspond to the Q codewords, so as to reduce signaling overheads.

In a possible implementation, the method further includes: For an $i^{th}$ codeword in the Q codewords, the second device outputs L1 first estimated sequences corresponding to the $i^{th}$ codeword to a transport layer corresponding to an $(i+1)^{th}$ codeword, where L1 is less than or equal to a list dimension L of a list decoder, and i=1, 2, ..., Q-1; and for the $(i+1)^{th}$ codeword in the Q codewords, the second device separately performs SIC detection on the L1 first estimated sequences to obtain L1 second estimated sequences, and decodes the L1 second estimated sequences to obtain L2 third estimated sequences, where L2 is greater than or equal to L1. The L2 third estimated sequences are used to determine data corresponding to the Q codewords. The second device may decode the latter codeword by using a decoding result of the former codeword, to increase a decoding gain. For example, in a decoding process, the second device may reserve a plurality of decoding results (estimated sequences) of the $i^{th}$ codeword, to decode the $(i+1)^{th}$ codeword, so that incorrect transmission caused by an error in the estimated sequence can be reduced as much as possible. In addition, joint decoding may be established for the Q codewords, that is, the data of the Q codewords is associated, so that the data of the Q codewords can be checked by using one CRC, to reduce CRC overheads and a code rate loss.

In a possible implementation, that the first MCS index indicates code rates and modulation orders that respectively correspond to the Q codewords includes:

The first MCS index corresponds to Q sub-indexes, the Q sub-indexes are in one-to-one correspondence with the Q codewords, and one of the Q sub-indexes corresponds to one group of a code rate and a modulation order.

In a possible implementation, the method further includes: The second device sends indication information to the first device, where the indication information indicates whether the second device uses a first receiving mode.

In a possible implementation, Q is equal to P, and the Q codewords are one-to-one mapped to the P transport layers; or Q is less than P, and one of the Q codewords is mapped to one or two layers in the P transport layers.

For technical effects brought by the second aspect and the possible implementations of the second aspect, refer to descriptions of technical effects of the first aspect and the possible implementations of the first aspect.

According to a third aspect, an embodiment of this application provides a communication apparatus. The communication apparatus has functions of implementing actions in the method embodiment of any one of the first aspect and the second aspect. For beneficial effects, refer to the descriptions of the first aspect and the second aspect. Details are not described herein again.

The communication apparatus may be the first device in the first aspect, or the communication apparatus may be an apparatus that can implement the method provided in the first aspect, for example, a chip or a chip system. In a possible design, the communication apparatus includes a corresponding means (means) or module configured to perform the method in the first aspect. For example, the communication apparatus includes a processing unit (sometimes referred to as a processing module or a processor) and/or a transceiver unit (sometimes referred to as a transceiver module or a transceiver). The transceiver unit may include a sending unit and a receiving unit. It may also be understood as that the sending unit and the receiving unit are a same functional module. Alternatively, the transceiver unit is understood as a general term of the sending unit and the receiving unit, and the sending unit and the receiving unit may be different functional modules. These units (modules) may perform a corresponding function in the method example in the first aspect. For details, refer to the detailed descriptions in the method example. Details are not described herein again.

The communication apparatus may be the second device in the second aspect, or the communication apparatus may be an apparatus that can implement the method provided in the second aspect, for example, a chip or a chip system. In a possible design, the communication apparatus includes a corresponding means (means) or module configured to perform the method in the second aspect. For example, the communication apparatus includes a processing unit (sometimes referred to as a processing module or a processor) and/or a transceiver unit (sometimes referred to as a transceiver module or a transceiver). The transceiver unit may include a sending unit and a receiving unit. It may also be understood as that the sending unit and the receiving unit are a same functional module. Alternatively, the transceiver unit is understood as a general term of the sending unit and the receiving unit, and the sending unit and the receiving unit may be different functional modules. These units (modules) may perform a corresponding function in the method example in the second aspect. For details, refer to the detailed descriptions in the method example. Details are not described herein again.

According to a fourth aspect, an embodiment of this application provides a communication apparatus. The communication apparatus may be the communication apparatus in any one of the third aspect and the fourth aspect, or a chip or a chip system disposed in the communication apparatus in any one of the third aspect and the fourth aspect. The communication apparatus may be a first device or a second device. The communication apparatus includes a communication interface and a processor, and optionally, further includes a memory. The memory is configured to store a computer program. The processor is coupled to the memory and the communication interface. When the processor reads the computer program or instructions, the communication apparatus is enabled to perform the method performed by the first device or the second device in the foregoing methods.

According to a fifth aspect, an embodiment of this application provides a communication apparatus. The communication apparatus includes an input/output interface and a logic circuit. The input/output interface is configured to input and/or output information. The logic circuit is configured to perform the method according to any one of the first aspect and the second aspect.

According to a sixth aspect, an embodiment of this application provides a chip system. The chip system includes a processor, and may further include a memory and/or a communication interface, configured to implement the method according to any one of the first aspect and the second aspect. In a possible implementation, the chip system further includes a memory, configured to store a computer program. The chip system may include a chip, or may include a chip and another discrete component.

According to a seventh aspect, an embodiment of this application provides a communication system. The communication system includes a first device and a second device. The first device is configured to perform the method performed by the first device in the first aspect, and the second device is configured to perform the method performed by the second device in the second aspect. Certainly, the communication system may include more first devices or more second devices.

According to an eighth aspect, this application provides a computer-readable storage medium. The computer-readable storage medium stores a computer program, and when the computer program is run, the method in any one of the first aspect and the second aspect is implemented.

According to a ninth aspect, a computer program product is provided. The computer program product includes computer program code, and when the computer program code is run, the method in any one of the first aspect and the second aspect is performed.

For beneficial effects of the third aspect to the ninth aspect and the implementations of the third aspect to the ninth aspect, refer to descriptions of beneficial effects of the first aspect and the second aspect and the implementations of the first aspect and the second aspect.

## BRIEF DESCRIPTION OF DRAWINGS

FIG. 1 is a diagram of an architecture of a communication system to which an embodiment of this application is applicable;

FIG. 2 is a schematic flowchart of multi-codeword transmission according to an embodiment of this application;

FIG. 3 is a diagram of a decoding principle of a receive end corresponding to FIG. 2;

FIG. 4 is a schematic flowchart of a communication method according to an embodiment of this application;

FIG. 5 is another schematic flowchart of multi-codeword transmission to which an embodiment of this application is applicable;

FIG. 6 is a diagram in which one TB corresponds to one CW according to an embodiment of this application;

FIG. 7 is a diagram in which one TB corresponds to a plurality of CWs according to an embodiment of this application;

FIG. 8 is a diagram of a decoding principle of a receive end corresponding to FIG. 5;

FIG. 9 is a diagram of another decoding principle of a receive end corresponding to FIG. 5;

FIG. 10 is a diagram of a structure of a communication apparatus according to an embodiment of this application; and

FIG. 11 is a diagram of another structure of a communication apparatus according to an embodiment of this application.

## DESCRIPTION OF EMBODIMENTS

The technical solutions provided in embodiments of this application may be applied to a 5th generation (5th generation, 5G) mobile communication system, for example, a new radio (new radio, NR) system, or applied to a long term evolution (Long term evolution, LTE) system, a non-terrestrial network (non-terrestrial network, NTN) system, or may be further applied to a next generation mobile communication system or another similar communication system. The technical solutions provided in embodiments of this application may also be applied to a vehicle to everything (vehicle to everything, V2X) system, an internet of things (internet of things, IoT) system, a narrowband internet of things (narrowband internet of things, NB-IoT) system, and the like, for example, a wireless fidelity (wireless fidelity, Wi-Fi)-based IoT network or a wearable Wi-Fi network.

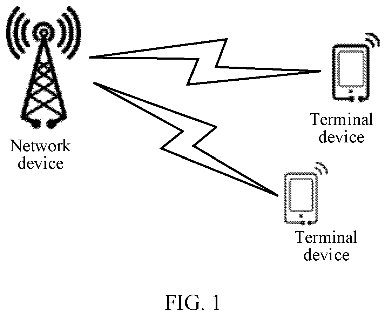

In an example, FIG. 1 is a diagram of a network architecture of a communication system to which an embodiment of this application is applicable. The communication system may include a network device and two terminal devices. The two terminal devices may be mobile terminal devices and/or any other suitable devices used for communication in a wireless communication system, and may be both connected to the network device. Both the two terminal devices can communicate with the network device. Certainly, a quantity of terminal devices in FIG. 1 is merely an example, and there may be fewer or more terminal devices. In addition, the terminal device in FIG. 1 is also an example. For example, the terminal device may alternatively be an internet of things device such as a smart water meter.

In embodiments of this application, the terminal device is a device having a wireless transceiver function, and may send a signal to the network device, or receive a signal from the network device. The terminal device may include user equipment (user equipment, UE), and sometimes is also referred to as a terminal, an access station, a UE station, a remote station, a wireless communication device, a user apparatus, or the like. The terminal device is configured to connect persons, objects, machines, and the like, and may be widely used in various scenarios. For example, the terminal device includes but is not limited to terminal devices in the following scenarios: cellular communication, device-to-device (device-to-device, D2D), V2X, satellite communication, machine-to-machine/machine-type communication (machine-to-machine/machine-type communication, M2M/MTC), IoT, virtual reality (virtual reality, VR), augmented reality (augmented reality, AR), industrial control (industrial control), self driving (self driving), remote medical (remote medical), a smart grid (smart grid), smart furniture, a smart office, a smart wearable, smart transportation, a smart city (smart city), an uncrewed aerial vehicle, and a robot.

By way of example but not limitation, in embodiments of this application, the terminal device may alternatively be a wearable device. The wearable device may also be referred to as a wearable intelligent device, an intelligent wearable device, or the like, and is a general term of wearable devices that are intelligently designed and developed for daily wear by using a wearable technology, for example, glasses, gloves, watches, clothes, and shoes. If the various terminal devices described above are located in a vehicle (for example, placed in the vehicle or installed in the vehicle), the terminal devices may be all considered as vehicle-mounted terminal devices. For example, the vehicle-mounted terminal device is also referred to as an on-board unit (on-board unit, OBU). The terminal device in this application may alternatively be a vehicle-mounted module, a vehicle-mounted assembly, a vehicle-mounted component, a vehicle-mounted chip, or a vehicle-mounted unit that is built in the vehicle as one or more components or units. The vehicle uses the vehicle-mounted module, the vehicle-mounted assembly, the vehicle-mounted component, the vehicle-mounted chip, or the vehicle-mounted unit that is built in the vehicle, to implement the method in this application.

In embodiments of this application, a communication apparatus configured to implement functions of the terminal device may be the terminal device, or may be an apparatus, for example, a chip system, that can support the terminal device in implementing the functions. The apparatus may be installed in the terminal device. In the technical solutions provided in embodiments of this application, the technical solutions provided in embodiments of this application are described by using an example in which the apparatus configured to implement the functions of the terminal device is the terminal device.

In embodiments of this application, the network device may be an access device through which the terminal device accesses a mobile communication system in a wireless manner, for example, includes an access network (access network, AN) device, for example, a base station. The network device may alternatively be a device that communicates with the terminal device through an air interface. The network device may include an evolved NodeB (evolved NodeB) (also referred to as an eNB or an e-NodeB for short) in an LTE system or a long term evolution (long term evolution-advanced, LTE-A) system. The network device may alternatively include a next-generation NodeB (next generation NodeB, gNB) in a 5G NR system. The network device may alternatively include an access node or the like in a wireless fidelity (wireless fidelity, Wi-Fi) system. The network device may alternatively be a station (station), a relay station, a satellite, a vehicle-mounted device, a future evolved public land mobile network (Public Land Mobile Network, PLMN) device, a device in a D2D network, a device in a machine-to-machine (machine-to-machine, M2M) network, a device in an internet of things IoT network, a network device in a PLMN network, or the like. A specific technology and a specific device form that are used by the network device are not limited in embodiments of this application.

In addition, the base station in embodiments of this application may include a central unit (central unit, CU) and a distributed unit (distributed unit, DU), and a plurality of DUs may be centrally controlled by one CU. The CU and the DU may be divided based on a protocol layer function that the CU and the DU each have in a wireless network. For example, functions of a packet data convergence protocol (packet data convergence protocol, PDCP) layer and a protocol layer above the packet data convergence protocol layer are set on the CU, and functions of protocol layers below the PDCP layer, for example, a radio link control (radio link control, RLC) layer and a medium access control (medium access control, MAC) layer, are set on the DU. It should be noted that such protocol layer division is merely an example, and division may be performed at another protocol layer. A radio frequency apparatus may be remotely disposed and not placed in the DU, or may be integrated into the DU, or may be partially remotely disposed and partially integrated into the DU. This is not limited in embodiments of this application. In addition, in some embodiments, a control plane (control plane, CP) and a user plane (user plane, UP) of the CU may be separated into different entities for implementation, where the entities are respectively a control plane CU entity (CU-CP entity) and a user plane CU entity (CU-UP entity). The control plane CU-CP of the CU further includes a further division architecture. In other words, an existing CU-CP is further divided into a CU-CP 1 and a CU-CP 2. The CU-CP 1 includes various radio resource management functions, and the CU-CP 2 includes only an RRC function and a PDCP-C function (to be specific, a basic function of control plane signaling at the PDCP layer). In this network architecture, signaling generated by the CU may be sent to the terminal device through the DU, or signaling generated by the UE may be sent to the CU through the DU. The DU may transparently transmit the signaling to the UE or the CU by directly encapsulating the signaling at the protocol layer without parsing the signaling. In this network architecture, the CU is classified as a network device on a radio access network (radio access network, RAN) side. In addition, the CU may alternatively be classified as a network device on a core network (core network, CN) side. This is not limited in this application.

In embodiments of this application, a communication apparatus configured to implement functions of the network device may be the network device, or may be an apparatus, for example, a chip system, that can support the network device in implementing the functions. The apparatus may be installed in the network device. In the technical solutions provided in embodiments of this application, the technical solutions provided in embodiments of this application are described by using an example in which the apparatus configured to implement the functions of the network device is the network device.

In embodiments of this application, unless otherwise specified, a quantity of nouns represents "a singular noun or a plural noun", that is, "one or more". "At least one" means one or more, and "a plurality of" means two or more. "And/or" describes an association relationship between associated objects, and indicates that three relationships may exist. For example, A and/or B may indicate the following three cases: A exists alone, both A and B exist, and B exists alone, where A and B may be singular or plural. The character "/" generally indicates an "or" relationship between the associated objects. For example, A/B indicates A or B. "At least one of the following items (pieces)" or a similar expression thereof means any combination of these items, including any combination of singular items (pieces) or plural items (pieces). For example, at least one item (piece) of a, b, or c indicates a, b, c, a and b, a and c, b and c, or a, b, and c, where a, b, and c may be singular or plural.

Ordinal numerals such as "first" and "second" mentioned in embodiments of this application are used to distinguish between a plurality of objects, and are not intended to limit sizes, content, an order, a time sequence, application scenarios, priorities, importance degrees, or the like of the plurality of objects. For example, a first bit sequence and a second bit sequence may be a same bit sequence, or may be different bit sequences. In addition, such names do not indicate that the two bit sequences are different in length, content, priority, application scenario, importance degrees, or the like.

Embodiments of this application mainly relate to a single-user multiple-input and multiple-output (single-user multiple-input and multiple-output, SU-MIMO) solution. For ease of understanding embodiments of this application, the following first describes related concepts in embodiments of this application.

To improve a system throughput, a multiple-input and multiple-output (multiple-input and multiple-output, MIMO) technology is introduced. The MIMO technology refers to the use of a plurality of transmit antennas and a plurality of receive antennas respectively at a transmit end and a receive end. That is, there are a plurality of independent channels between the transmit end and the receive end. In other words, there is sufficient spacing between antenna elements. Therefore, the MIMO technology can eliminate inter-line signal correlation, improve signal link performance, and increase a data throughput. The transmit end is a terminal device, and the receive end may be a base station. Alternatively, the transmit end is a base station, and the receive end may be a terminal device.

In an NR system, a main processing procedure of transmitting data at a physical layer based on the MIMO technology is as follows: A MAC layer sends the data to the physical layer in a form of a transport block (transport block, TB). It may also be considered that the TB is a basic data unit transmitted between the MAC layer and the physical layer, and a TB size (TB size, TBS) is determined in a transmission process and does not change subsequently. After receiving the TB, the physical layer processes the TB into a CW. A process of converting the TB into the CW may also be understood as a bit-level encoding process. Generally, operations such as CRC, code block segmentation, channel encoding, rate matching, and code block concatenation are performed on a bit stream corresponding to the TB, and a data unit output after the code block concatenation is the CW.

The NR system may support 2-CW transmission. The transmit end may perform 1-CW or 2-CW transmission. For example, the transmit end may map one CW to different layers of MIMO for transmission, or may map two CWs to different layers of MIMO for transmission. Embodiments of this application mainly relate to mapping two CWs to different layers of MIMO for transmission. Therefore, the following mainly describes related content of mapping the two CWs to the different layers of MIMO for transmission.

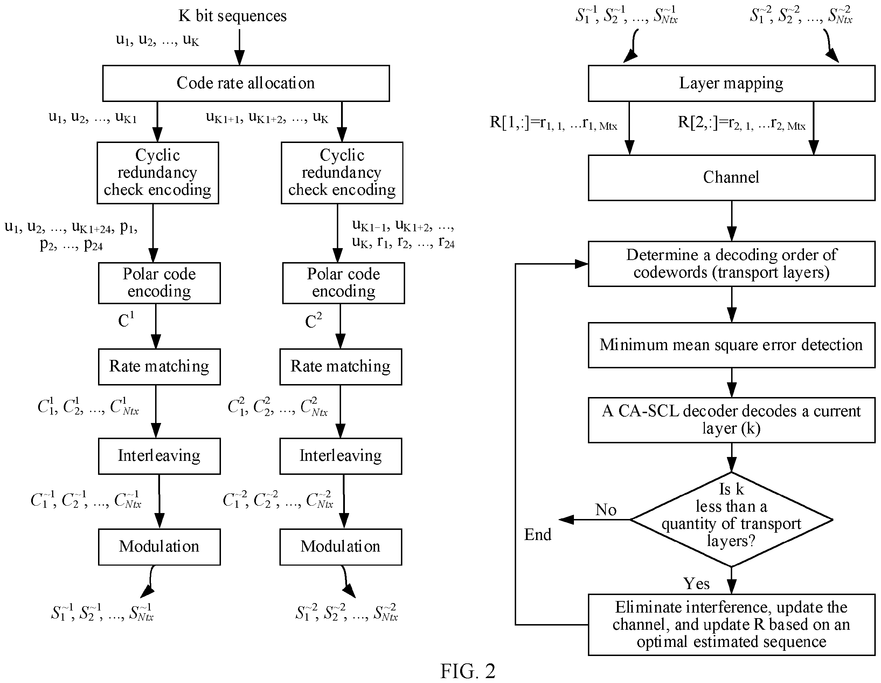

FIG. 2 is a schematic flowchart of 2-CW information transmission. The procedure shown in FIG. 2 includes an encoding procedure at a transmit end and a decoding procedure at a receive end. FIG. 2 uses an example in which a TB of the transmit end occupies K bits. That is, data to be sent by the transmit end is a bit sequence $\{u_1, u_2, ..., u_K\}$. The transmit end first performs code rate allocation based on a quantity of layers of MIMO. For example, there are two transport layers of MIMO, and the bit sequence $\{u_1, u_2, ..., u_K\}$ may be divided into two sequences. It is assumed that lengths of the two sequences are K1 and K-K1, where the two sequences may be denoted as $\{u_1, u_2, ..., u_{K1}\}$ and $\{u_{K1+1}, u_{K1+2}, ..., u_K\}$. $\{u_1, u_2, ..., u_{K1}\}$ and $\{u_{K1+1}, u_{K1+2}, ..., u_K\}$ are separately checked based on a CRC code. It is assumed that a length of the CRC code is 24. In this case, a length obtained by checking $\{u_1, u_2, ..., u_{K1}\}$ based on the CRC code is K1+24, that is, $\{u_1, u_2, ..., u_{K1+24}, p_1, p_2, ..., p_{24}\}$; and a length obtained by checking $\{u_{K1+1}, u_{K1+2}, ..., u_K\}$ based on the CRC code is K-K1+24, that is, $\{u_{K1+1}, u_{K1+2}, ..., u_K, n, r_2, ..., r_{24}\}$. Polar encoding and rate matching are performed on both $\{u_1, u_2, ..., u_{K1+24}, p_1, p_2, ..., p_{24}\}$ and $\{u_{K1+1}, u_{K1+2}, ..., u_K, r_1, r_2, ..., r_{24}\}$. It is assumed that a codeword used by $\{u_1, u_2, ..., u_{K1+24}, p_1, p_2, ..., p_{24}\}$ is $C^1$, a codeword used by $\{u_{K1+1}, u_{K1+2}, ..., u_K, r_1, r_2, ..., r_{24}\}$ is $C^2$, and lengths of $C^1$ and $C^2$ are both N. Correspondingly, the encoding and the rate matching may be performed on $\{u_1, u_2, ..., u_{K1+24}, p_1, p_2, ..., p_{24}\}$ to obtain $\{C_1^1, C_2^1, ..., C_{Ntx}^1\}$, and the encoding and the rate matching may be performed on $\{u_{K1+1}, u_{K1+2}, ..., u_K, r_1, r_2, ..., r_{24}\}$ to obtain $\{C_1^2, C_2^2, ..., C_{Ntx}^2\}$.

Interleaving is separately performed on $\{C_1^1, C_2^1, ..., C_{Ntx}^1\}$ and $\{C_1^2, C_2^2, ..., C_{Ntx}^2\}$ by using an encoding interleaver to change $\{C_1^1, C_2^1, ..., C_{Ntx}^1\}$ into $\{C_1^{\sim 1}, C_2^{\sim 1}, ..., C_{Ntx}^{\sim 1}\}$ through the interleaving, and to change $\{C_1^2, C_2^2, ..., C_{Ntx}^2\}$ into $\{C_1^{\sim 2}, C_2^{\sim 2}, ..., C_{Ntx}^{\sim 2}\}$ through the interleaving. The interleaved sequences are modulated, where $\{C_1^{\sim 1}, C_2^{\sim 1}, ..., C_{Ntx}^{\sim 1}\}$ may be modulated to obtain a modulation symbol $\{S_1^{\sim 1}, S_2^{\sim 1}, ..., S_{Mtx}^{\sim 1}\}$, and $\{C_1^{\sim 2}, C_2^{\sim 2}, ..., C_{Ntx}^{\sim 2}\}$ may be modulated to obtain a modulation symbol $\{S_1^{\sim 2}, S_2^{\sim 2}, ..., S_{Mtx}^{\sim 2}\}$. The modulation symbols are mapped to the transport layers, and same data may be transmitted at each transport layer, to ensure transmission reliability as much as possible. As shown in FIG. 2, an example in which there are two transport layers is used. $\{S_1^{\sim 1}, S_2^{\sim 1}, ..., S_{Mtx}^{\sim 1}\}$ is mapped to a first layer, and $\{S_1^{\sim 2}, S_2^{\sim 2}, ..., S_{Mtx}^{\sim 2}\}$ is mapped to a second layer. $\{S_1^{\sim 1}, S_2^{\sim 1}, ..., S_{Mtx}^{\sim 1}\}$ is sent in a form of R[1,:] = $r_{1,1}$, ... $r_{1,Mtx}$ through a channel, and $\{S_1^{\sim 2}, S_2^{\sim 2}, ..., S_{Mtx}^{\sim 2}\}$ is sent in a form of R[2,:] = $r_{2,1}$, ... $r_{2,Mtx}$ through a channel. It should be understood that different data may be transmitted at different transport layers, to improve transmission efficiency.

The receive end may use SIC for decoding. For example, the receive end may perform joint decoding by using a minimum mean square error (minimum mean square error, MMSE) and SIC. For another example, the receive end may perform joint decoding by using zero forcing (zero forcing, ZF) equalization and SIC. Specifically, the receive end first determines a decoding order of a plurality of codewords, and successively decodes the codewords in the decoding order of the codewords. The following describes a decoding process at the receive end in which a receiver uses an MMSE-SIC decoding scheme.

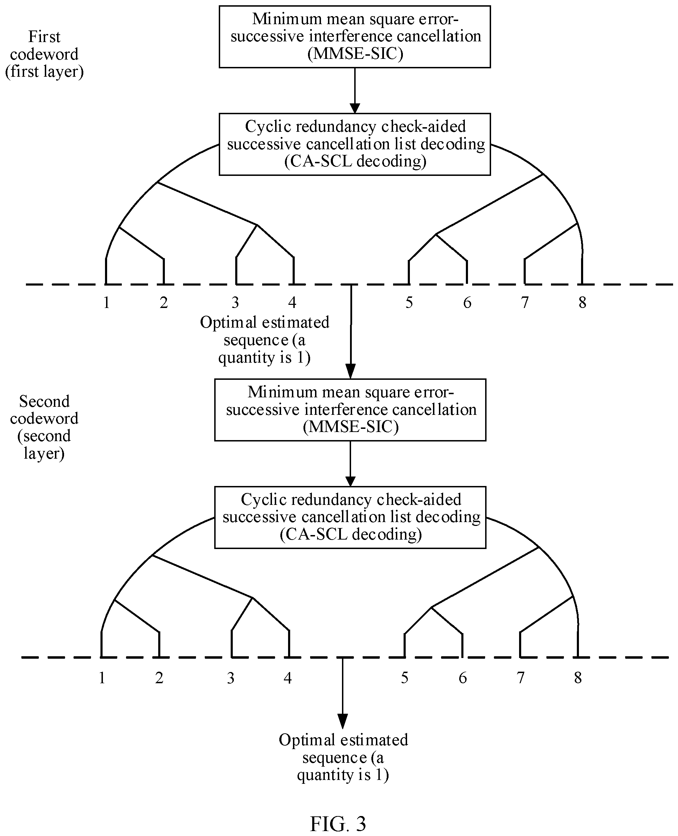

FIG. 3 is a diagram of a principle of decoding each transport layer by a receive end in an MMSE-SIC decoding scheme. In FIG. 3, an example in which a transmit end transmits two codewords through two transport layers is used. In the following descriptions, for example, the two transport layers include a first layer and a second layer, and a decoding order indicates to decode a first codeword before decoding a second codeword. The first codeword is transmitted through the first layer, and the second codeword is transmitted through the second layer.

First, the receive end performs MMSE estimation on a data symbol transmitted at the first layer, to obtain a first estimated symbol. Then, the receive end sends the first estimated symbol to a CRC-aided (CRC-Aided, CA) successive cancellation list (successive cancellation list, SCL) decoder (decoding) for decoding. The CA-SCL decoder generates eight decoding paths, which may be understood as that the CA-SCL decoder may obtain eight second estimated sequences through the decoding. A second estimated sequence that passes CRC in the eight second estimated sequences is an estimated sequence (also referred to as an optimal estimated sequence) output by the CA-SCL decoder, where the optimal estimated sequence is the estimated sequence that passes the CRC. If none of the eight estimated sequences fail to pass the CRC, the decoding fails. Subsequently, the receive end re-modulates the optimal estimated sequence output by the CA-SCL decoder into a modulation symbol sequence corresponding to the first layer, and then eliminates impact on data at a next layer from an original received symbol sequence based on the modulation symbol sequence, to obtain a received symbol sequence in which the impact is eliminated. The second layer is decoded based on the received number sequence in which the impact of the first layer is eliminated. Decoding the second layer based on the received number sequence in which the impact of the first layer is eliminated is similar to decoding the first layer. To be specific, MMSE estimation is performed on the received number sequence in which the impact of the first layer is eliminated and that is transmitted at the second layer, and decoding is performed by using the CA-SCL decoder. For details, refer to a process of decoding the first layer. Details are not described herein again.

In the procedure shown in FIG. 2, the transmit end first performs code rate allocation based on the quantity of layers of MIMO, and then performs CRC check, and therefore more CRCs need to be set. Accordingly, overheads of CRC checking bits are higher, causing a larger code rate loss. In addition, the code rate allocation is initially performed based on the quantity of transport layers, the data at the different transport layers is separately checked by using an independent CRC, and then the polar encoding is performed. Therefore, obtained codewords are independent of each other without association. In the decoding process, the receive end cannot perform decoding by utilizing correlation between the codewords. That is, a decoding gain of the receive end is limited.

In view of this, solutions of embodiments of this application are provided. In embodiments of this application, a transmit end may first check an original bit sequence based on a CRC code, and then performs code rate allocation. In this way, data at different transport layers is coupled by using the CRC, so that the data at the different transport layers is associated. Therefore, in a decoding process, a receive end may decode the latter transport layer (codeword) by using a decoding result of the former transport layer (codeword), to increase a decoding gain of the receive end. For example, in a decoding process, a second device may reserve a plurality of decoding results (estimated sequences) of an $i^{th}$ codeword, to decode an $(i+1)^{th}$ codeword, so that incorrect transmission caused by an error in the estimated sequence can be reduced as much as possible. In addition, joint decoding may be established for Q codewords, that is, data of the Q codewords is associated, so that the data of the Q codewords can be checked by using one CRC, to reduce CRC overheads and a code rate loss.

The following describes the technical solutions provided in embodiments of this application with reference to the accompanying drawings.

An embodiment of this application provides a communication method. The method may be applied to any communication system, provided that a transmit end communicates with a receive end. In the following descriptions, the communication method is applied to the communication system shown in FIG. 1. Unless otherwise specified, a "transport layer" and a "layer" in the following belong to a same concept and can be replaced with each other.

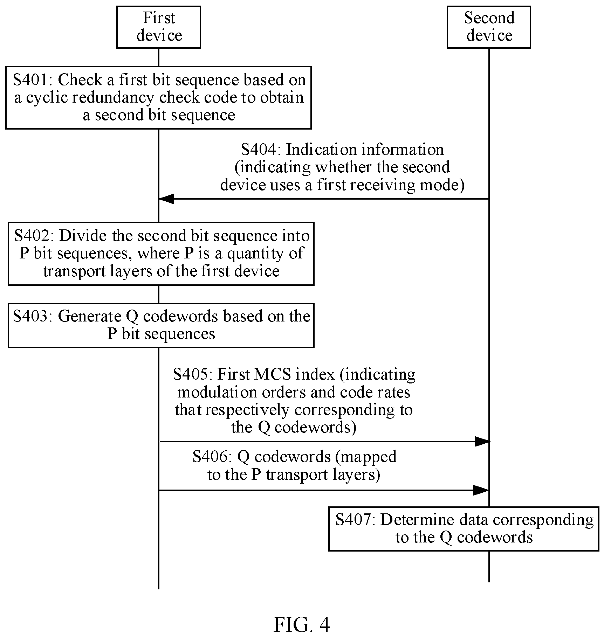

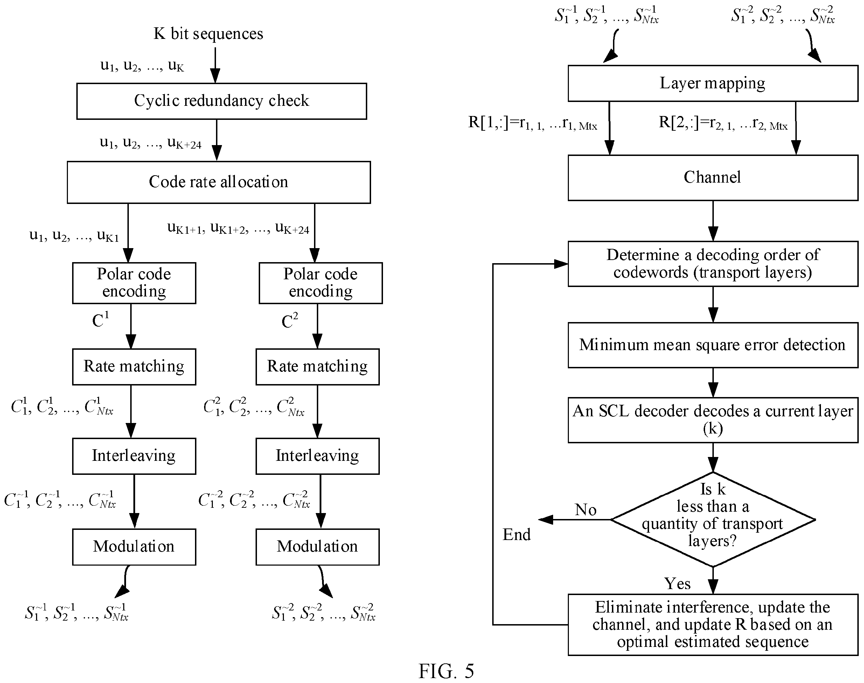

FIG. 4 is a schematic flowchart of a communication method according to an embodiment of this application. In the following descriptions, an example in which the communication method is performed by a first device and a second device is used. The first device may be a terminal device, and the second device may be a network device. In the following descriptions, an example in which the first device sends data to the second device is used, and the first device sends the data to the second device through multi-codeword transmission. In other words, the first device maps a plurality of codewords to a plurality of transport layers, and sends the data to the second device through the plurality of transport layers. For ease of understanding, reference may be made to an encoding procedure of the first device shown in FIG. 5.

S401: The first device checks a first bit sequence based on a CRC code, to obtain a second bit sequence.

The first bit sequence is a bit stream corresponding to original data sent by the first device to the second device. In this embodiment of this application, when sending the data to the second device, the first device may check the first bit sequence based on the CRC code, that is, perform CRC on the first bit sequence. It should be understood that the second bit sequence may be generated by performing CRC check on the first bit sequence. For example, as shown in FIG. 5, if the first bit sequence is K bits (denoted as $\{u_1, u_2,..., u_K\}$) and a length of the CRC code is 24, the second bit sequence is K+24 bits (denoted as $\{u_1, u_2, ..., u_{K+24}\}$).

S402: The first device divides the second bit sequence into P bit sequences, where P is a quantity of transport layers of the first device, and P is greater than or equal to 2.

In this embodiment of this application, after the second bit sequence is obtained, code rate allocation may be performed. For example, the first device may determine a code rate to perform code rate allocation on the second bit sequence, for example, divide the second bit sequence into the P bit sequences. The first device determines the code rate differently based on a receiving mode (for example, a first receiving mode) of the second device. Details are described below.

The first device may divide the second bit sequence into the P bit sequences based on the quantity P of transport layers of the first device, and one of the P bit sequences corresponds to one of the P transport layers. In a possible implementation, the first device may divide the second bit sequence into the P bit sequences based on a capacity of each of the P transport layers, which may also be understood as that the first device matches the second bit sequence to the P transport layers based on capacities of the P transport layers. Transport layers with different capacities may correspond to different lengths of bit sequences. Optionally, the capacity of each transport layer is a capacity of the transport layer in the first receiving mode of the second device.

A capacity of any one of the P transport layers may be based on transmit power, interference power, and noise power of the transport layer. For example, a capacity $C_k$ of a $k^{th}$ transport layer in the P transport layers satisfies the following formula:

$$C_k = \log\left(1 + P_k \boldsymbol{h}_k^* \left(N_0 \boldsymbol{I}_{N_r} + \sum_{i=k+1}^{N_t} P_i \boldsymbol{h}_k \boldsymbol{h}_k^*\right)^{-1} \boldsymbol{h}_k\right),$$

where

k=1, 2, ..., P, $P_k$ is transmit power of each antenna of the first device, $N_0$ is noise power, $\boldsymbol{h}_k$ is a $k^{th}$ column for a channel H, $N_r$ is a quantity of receive antennas, $N_t$ is a quantity of transmit antennas, $\boldsymbol{h}_k$ is the $k^{th}$ column for the channel H, and $\boldsymbol{h}_k^*$ is a conjugate transpose of $h_k$.

FIG. 5 is used as an example. To be specific, the first device has two transport layers. In this case, the first device may divide the second bit sequence into two bit sequences based on capacities of the two transport layers in the first receiving mode. A capacity $C_1$ of a first layer and a capacity $C_2$ of a second layer may be calculated according to the foregoing formula. A length of a bit sequence corresponding to the first layer is $K_1 = \left\lceil \frac{C_1}{C_1+C_2} \times (K+24) \right\rceil$, and a length of a bit sequence corresponding to the second layer is $K_2 = K + 24 - K_1$. As shown in FIG. 5, the bit sequence corresponding to the first layer is $\{u_1, u_2, ..., u_{K1}\}$, and the bit sequence corresponding to the second layer is $\{u_{K1+1}, u_{K1+2}, ..., u_{K+24}\}$. The first device matches bit sequences with corresponding lengths based on capacities of different transport layers, so that a CW can be separately designed for a bit sequence at each transport layer, to improve an encoding gain.

S403: The first device generates Q codewords based on the P bit sequences.

After obtaining the P bit sequences, the first device separately performs polar (Polar) code encoding on the P bit sequences to obtain corresponding polar code codewords, performs rate matching and interleaving to obtain the Q codewords, and finally maps modulation symbols of the Q codewords to the P transport layers and sends the modulation symbols to the second device.

FIG. 5 is used as an example. To be specific, P=2 and Q=2. Polar code encoding is performed on $\{u_1, u_2, ..., u_{K1}\}$ to obtain a polar code codeword $C^1$, and polar code encoding is performed on $\{u_{K1+1}, u_{K1+2}, ..., u_{K+24}\}$ to obtain a polar code codeword $C^2$. Rate matching is separately performed on the polar code codewords $C^1$ and $C^2$. It is assumed that lengths of $C^1$ and $C^2$ are both N. The polar code encoding and the rate matching may be performed on $\{u_1, u_2, ..., u_{K1}\}$ to obtain $\{C_1^1, C_2^1, ..., C_{Ntx}^1\}$, and the polar code encoding and the rate matching may be performed on $\{u_{K1+1}, u_{K1+2}, ..., u_{K+24}\}$ to obtain $\{C_1^2, C_2^2, ..., C_{Ntx}^2\}$. Interleaving is separately performed on $\{C_1^1, C_2^1, ..., C_{Ntx}^1\}$ and $\{C_1^2, C_2^2, ..., C_{Ntx}^2\}$ by using an interleaver, to obtain the Q codewords to change $\{C_1^1, C_2^1, ..., C_{Ntx}^1\}$ into $\{C_1^{\sim 1}, C_2^{\sim 1}, ..., C_{Ntx}^{\sim 1}\}$ through the interleaving, and change $\{C_1^2, C_2^2, ..., C_{Ntx}^2\}$ into $\{C_1^{\sim 2}, C_2^{\sim 2}, ..., C_{Ntx}^{\sim 2}\}$ through the interleaving. The interleaved sequences are modulated, where $\{C_1^{\sim 1}, C_2^{\sim 1}, ..., C_{Ntx}^{\sim 1}\}$ may be modulated to obtain a modulation symbol $\{S_1^{\sim 1}, S_2^{\sim 1}, ..., S_{Mtx}^{\sim 1}\}$, and $\{C_1^{\sim 2}, C_2^{\sim 2}, ..., C_{Ntx}^{\sim 2}\}$ may be modulated to obtain a modulation symbol $\{S_1^{\sim 2}, S_2^{\sim 2}, ..., S_{Mtx}^{\sim 2}\}$. Subsequently, the modulation symbols are mapped to the transport layer, and same data may be transmitted at each transport layer, to ensure transmission reliability as much as possible. Alternatively, different data may be transmitted at different transport layers, to improve a transmission rate.

In this embodiment of this application, when performing transmission based on a plurality of CWs, the first device first performs CRC code check on the original data bit stream, namely, the first bit sequence, and then performs code rate allocation, polar code encoding, rate matching, interleaving, modulation, and the like. In comparison with a current case in which code rate allocation is first performed, and then CRC code check, polar code encoding, rate matching, interleaving, and modulation are performed, because CRC code check is first performed, a quantity of CRCs that need to be set by the first device can be reduced. For example, two CRCs need to be set in FIG. 2, and only one CRC needs to be set in FIG. 5.

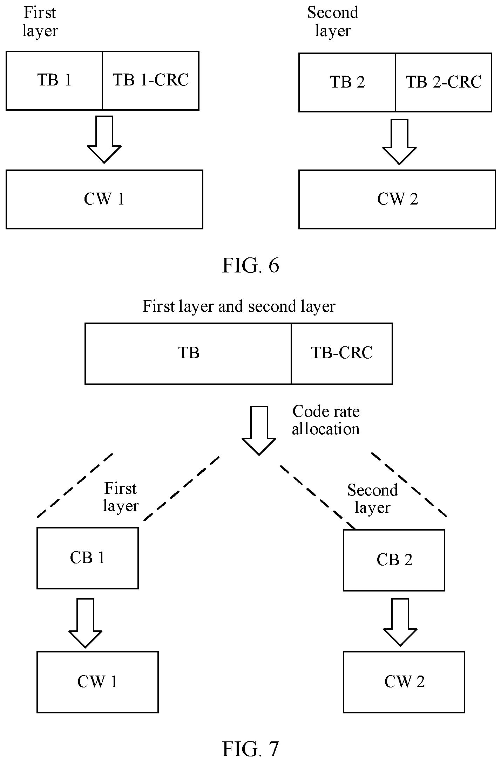

In addition, the CRC is first performed on the first bit sequence, and then the code rate allocation is performed. This is equivalent to coupling data at different transport layers by using the CRC, so that the data at the different transport layers is associated. For ease of understanding, refer to FIG. 6 and FIG. 7. FIG. 6 is a diagram in which one TB corresponds to one CW, and FIG. 7 is a diagram in which one TB corresponds to a plurality of CWs. FIG. 7 uses an example in which the plurality of CWs are two CWs.

FIG. 6 corresponds to FIG. 2. Code rate allocation is first performed on an original bit sequence to obtain a TB 1 and a TB 2, and then CRC, polar code encoding, rate matching, interleaving, and the like all are performed on the TB 1 and the TB 2 to obtain a CW 1 and a CW 2. The TB 1 corresponds to the CW 1, and the TB 2 corresponds to the CW 2. In other words, after the code rate allocation is performed on the original bit sequence, two bit sequences corresponding to two TBs are obtained, and one CW is generated for each bit sequence. That is, one TB corresponds to one CW. It may be understood as that data at two transport layers is independent of each other and has no association. FIG. 7 corresponds to FIG. 5. CRC is first performed on an original bit sequence, and then code rate allocation, polar code encoding, rate matching, interleaving, code block segmentation, and the like are performed, to obtain a CB 1 and a CB 2. In other words, the CRC is performed on the original bit sequence, and then the code rate allocation is performed, so that one TB corresponds to two CBs, that is, the two CBs share one CRC code. Encoding, rate matching, and interleaving are separately performed on the two CBs to obtain two CWs, namely, a CW 1 and a CW 2. That is, one TB corresponds to two CWs. It may be understood as that two CWs mapped to two transport layers correspond to one TB, and data at the two transport layers (codewords) is associated. It should be understood that, in this embodiment of this application, a purpose of first performing CRC on the first bit sequence is to couple the data at the different transport layers (codewords), so that the data at the different transport layers (codewords) is associated. This helps a receive end (for example, the second device) decode the latter transport layer (codeword) by using a decoding result of the former transport layer (codeword) in a decoding process, to increase a decoding gain of the receive end.

In this embodiment of this application, a process in which the first device generates the Q codewords based on the P bit sequences further involves TBS calculation. A TBS is related to a quantity (v) of transport layers, a code rate ($R_1$, $R_2$, ...), a modulation order ($Q_{m1}$, $Q_{m2}$, ...), and a quantity ($N_{RE}$) of resource elements (resource element, RE). For example, a quantity of message bits to be transmitted at each transport layer may be determined based on the quantity of transport layers, the code rate, the modulation order, and the quantity of REs, and then the TBS is determined based on the quantity of message bits. For example, a quantity of message bits to be transmitted at a first transport layer is $N_{info\_1}=N_{RE}\times Q_{m1}\times R_1\times v$, and a quantity of message bits to be transmitted at a second transport layer is $N_{info\_2}=N_{RE}\times Q_{m2}\times R_2\times v$. It can be learned that to determine the quantity of message bits at each transport layer, an MCS index needs to be determined, to determine a corresponding modulation order and code rate. In addition, when dividing the second bit sequence into the P bit sequences, the first device also needs to determine a receiving mode of the second device to determine the code rate. That is, the first device also needs to determine the MCS index, to further determine the code rate. Currently, an MCS index is separately determined for each codeword. In other words, one MCS index corresponds to one group of a code rate and a modulation order.

However, in this embodiment of this application, one MCS index may indicate code rates and modulation orders corresponding to a plurality of codewords. For example, Table 1 shows an MCS index table. In Table 1, Q=2 is used as an example. To be specific, one MCS index indicates code rates and modulation orders corresponding to two codewords. For ease of differentiation, in Table 1, an code rate and a modulation order corresponding to boldface correspond to one codeword, and an code rate and a modulation order corresponding to non-boldface correspond to the other codeword.

**Table 1**

| MCS index | Modulation order | | Code rate R × [1024] | | Spectral efficiency | |
|---|---|---|---|---|---|---|
| 0 | 2 | **2** | 120 | **120** | 0.2344 | **0.2344** |
| 1 | 2 | **2** | 193 | **157** | 0.3770 | **0.3066** |
| 2 | 2 | **2** | 449 | **193** | 0.8770 | **0.3770** |
| 3 | 4 | **2** | 378 | **251** | 1.4766 | **0.4902** |
| 4 | 4 | **2** | 490 | **308** | 1.9141 | **0.6016** |
| 5 | 4 | **2** | 616 | **379** | 2.4063 | **0.7402** |
| 6 | 6 | **2** | 466 | **449** | 2.7305 | **0.8770** |
| 7 | 6 | **2** | 517 | **526** | 3.0293 | **1.0273** |
| 8 | 6 | **2** | 567 | **602** | 3.3223 | **1.1758** |
| 9 | 6 | **2** | 616 | **679** | 3.6094 | **1.3262** |
| 10 | 6 | **4** | 666 | **340** | 3.9023 | **1.3281** |
| 11 | 6 | **4** | 719 | **378** | 4.2129 | **1.4766** |
| 12 | 6 | **4** | 772 | **434** | 4.5234 | **1.6953** |
| 13 | 6 | **4** | 822 | **490** | 4.8164 | **1.9141** |
| 14 | 6 | **4** | 873 | **553** | 5.1152 | **2.1602** |
| 15 | 8 | **4** | 682.5 | **616** | 5.3320 | **2.4063** |
| 16 | 8 | **4** | 711 | **658** | 5.5547 | **2.5703** |
| 17 | 8 | **6** | 754 | **438** | 5.8906 | **2.5664** |
| 18 | 8 | **6** | 797 | **466** | 6.2266 | **2.7305** |
| 19 | 8 | **6** | 841 | **517** | 6.5703 | **3.0293** |
| 20 | 8 | **6** | 885 | **567** | 6.9141 | **3.3223** |
| 21 | 8 | **6** | 916.5 | **616** | 7.1602 | **3.6094** |
| 22 | 8 | **6** | 948 | **666** | 7.4063 | **3.9023** |
| 23 | 10 | **6** | 805.5 | **719** | 7.8662 | **4.2129** |
| 24 | 10 | **6** | 853 | **772** | 8.3301 | **4.5234** |
| 25 | 10 | **6** | 900.5 | **822** | 8.7939 | **4.8164** |

(continued)

| MCS index | Modulation order | | Code rate R × [1024] | | Spectral efficiency | |
|---|---|---|---|---|---|---|
| 26 | 10 | **6** | 948 | **873** | 9.2578 | **5.1152** |
| 27 | 2 | **6** | Reserved | **910** | | **5.3320** |
| 28 | 4 | **6** | Reserved | **948** | | **5.5547** |
| 29 | 6 | **2** | Reserved | | | |

It can be learned from Table 1 that one MCS index may correspond to the modulation orders and the code rates respectively corresponding to the plurality of codewords. In other words, one MCS index corresponds to a plurality of groups of modulation orders and code rates, and one of the plurality of groups of modulation orders and code rates corresponds to one codeword. It should be noted that Table 1 is merely an example, and a modulation order and a code rate that specifically correspond to one codeword are not limited in this embodiment of this application.

In an alternative implementation, one MCS index may correspond to a plurality of MCS sub-indexes, and each MCS sub-index may correspond to a modulation order and an encoding rate of one codeword. For example, Table 2 shows another MCS index table.

**Table 2**

| MCS index | MCS sub-index 1 | MCS sub-index 2 | MCS sub-index k |
|---|---|---|---|
| 0 | **1** | **3** | **6** |
| 1 | **2** | **4** | **7** |
| 2 | **3** | **5** | **8** |
| 3 | **4** | **6** | **9** |
| 4 | **5** | **7** | **10** |
| 5 | **6** | **8** | **11** |
| 6 | **7** | **9** | **12** |
| 7 | **8** | **10** | **13** |
| 8 | **9** | **11** | **14** |
| 9 | **10** | **12** | **15** |
| 10 | **11** | **13** | **16** |
| 11 | **12** | **14** | **17** |
| 12 | **13** | **15** | **18** |
| 13 | **14** | **16** | **19** |
| 14 | **15** | **17** | **20** |
| 15 | **16** | **18** | **21** |
| 16 | **17** | **19** | **22** |
| 17 | **18** | **20** | **23** |
| 18 | **19** | **21** | **24** |
| 19 | **20** | **22** | **25** |
| 20 | **21** | **23** | **26** |
| 21 | **22** | **24** | **27** |
| 22 | **23** | **25** | **28** |
| 23 | **24** | **26** | **29** |
| 24 | **25** | **27** | **30** |
| 25 | **26** | **28** | **1** |

(continued)

| MCS index | MCS sub-index 1 | MCS sub-index 2 | MCS sub-index k |
|-----------|-----------------|-----------------|-----------------|
| 26 | **27** | **29** | **2** |
| 27 | **28** | **30** | **3** |
| 28 | **29** | **31** | **4** |
| 29 | **30** | **10** | Reserved |
| 30 | **31** | **2** | Reserved |
| 31 | **10** | **1** | Reserved |

It can be learned from Table 2 that one MCS index may correspond to a plurality of MCS sub-indexes. One MCS sub-index may correspond to one group of a modulation order and a code rate. One MCS sub-index corresponds to one codeword. Therefore, based on Table 2, the MCS index is determined. In other words, the plurality of MCS sub-indexes are determined. To be specific, the modulation orders and the code rates respectively corresponding to the plurality of codewords are determined. It should be noted that Table 2 is merely an example. A correspondence between an MCS index and an MCS sub-index is not limited in this embodiment of this application.

S404: The second device sends indication information to the first device, and correspondingly, the first device receives the indication information from the second device.

The indication information may indicate the receiving mode of the second device, so that the first device determines, based on the indication information, modulation orders and code rates respectively corresponding to the Q codewords. It may be understood that a manner in which the first device sends data varies with the receiving mode of the second device. For example, the second device receives the data from the first device in the first receiving mode, and the first device may send the data based on the procedure shown in FIG. 5. The second device receives the data from the first device in a second receiving mode, and the first device may send the data based on the procedure shown in FIG. 2. It may also be considered that the first device sends the data based on the procedure shown in FIG. 5, and the second device may receive the data from the first device in the first receiving mode. The first device sends the data based on the procedure shown in FIG. 2, and the second device may receive the data from the first device in the second receiving mode. Optionally, the receiving mode used by the second device may be represented by using a receiver used by the second device. For example, the second device uses an SIC receiver, and the receiving mode used by the second device is the first receiving mode.

The second device may provide the receiving mode of the second device for the first device. For example, the indication information indicates whether the second device uses the first receiving mode, so that the first device selects an appropriate MCS index. For example, the second device uses the first receiving mode, and the first device may determine, based on Table 1 or Table 2, the modulation orders and the code rates that correspond to the Q codewords, that is, determine the MCS index (for example, referred to as a first MCS index). The second device does not use the first receiving mode, and the first device may continue to use a current MCS index table (to be specific, one MCS index corresponds to a modulation order and a code rate of one codeword) to determine a to-be-used MCS index.

It may be understood that S404 is performed before S402.

S405: The first device sends the first MCS index to the second device, and correspondingly, the second device receives the first MCS index sent by the first device.

The first MCS index may indicate the code rates and the modulation orders that respectively correspond to the Q codewords. After receiving the first MCS index, the second device may determine, based on Table 1 or Table 2, the code rates and the modulation orders that respectively correspond to the Q codewords, and further decode the Q codewords, to determine data corresponding to the Q codewords.

S406: The first device sends the Q codewords to the second device through the P transport layers, and correspondingly, the second device receives, from the P transport layers, the Q codewords sent by the first device. Q is an integer greater than or equal to 2.

The Q codewords may be mapped to the P transport layers, and sent to the second device through the P transport layers. When Q is equal to P, the Q codewords are one-to-one mapped to the P transport layers. When Q is less than P, one of the Q codewords is mapped to one or two layers in the P transport layers.

For example, mapping relationships between the Q codewords and the P transport layers may be shown in Table 3. Table 3 uses Q=2 and P=2, 3, or 4 as an example.

**Table 3**

| Quantity of transport layers | Quantity of codewords | Mapping relationship between a codeword and a transport layer $i = 0,1,...,M_{symb}^{layer} - 1$ | |
|---|---|---|---|
| 2 | 2 | $x^{(0)}(i) = d^{(0)}(i)$ <br><br> $x^{(1)}(i) = d^{(1)}(i)$ | $M_{symb}^{layer} = M_{symb}^{(0)} = M_{symb}^{(1)}$ |
| 3 | 2 | $x^{(0)}(i) = d^{(0)}(i)$ <br><br> $x^{(1)}(i) = d^{(1)}(2i)$ <br> $x^{(2)}(i) = d^{(1)}(2i+1)$ | $M_{symb}^{layer} = M_{symb}^{(0)} = M_{symb}^{(1)}/2$ |
| 4 | 2 | $x^{(0)}(i) = d^{(0)}(2i)$ <br><br> $x^{(1)}(i) = d^{(0)}(2i+1)$ <br> $x^{(2)}(i) = d^{(1)}(2i)$ <br> $x^{(3)}(i) = d^{(1)}(2i+1)$ | $M_{symb}^{layer} = M_{symb}^{(0)}/2 = M_{symb}^{(1)}/2$ |

$M_{symb}^{layer}$ is a quantity of complex number-type modulation symbols of one transport layer. i is a modulation symbol index value of one transport layer, and i=0, 1, ..., or $M_{symb}^{layer}-1$. $M_{symb}^{(0)}$ is a quantity of complex number-type modulation symbols of a codeword 0, and $M_{symb}^{(1)}$ is a quantity of complex number-type modulation symbols of a codeword 1. $d^{(0)}$ is a complex number-type modulation symbol stream of the codeword 0, and $d^{(1)}$ is a complex number-type modulation symbol stream of the codeword 1. $x^{(0)}$ to $x^{(3)}$ are complex number-type modulation symbol streams of transport layers 0 to 3.

It can be learned from Table 3 that when P=3 and Q=2, the codeword 0 may be mapped to one transport layer, and the codeword 1 is mapped to the other two transport layers. For example, a length of a modulation symbol data stream of the codeword 0 is 2, that is, $[d^{(0)}(0), d^{(0)}(1)]$, and a length of a modulation symbol data stream of the codeword 1 is 4, that is, $[d^{(1)}(0), d^{(1)}(1), d^{(1)}(2), d^{(1)}(3)]$. It can be learned from Table 3 that:
$x^{(0)} = [d^{(0)}(0), d^{(0)}(1)]$, $x^{(1)} = [d^{(1)}(0), d^{(0)}(2)]$, $x^{(2)} = d^{(1)}(1), d^{(0)}(3)]$, and a quantity of modulation symbols of each transport layer is 2.

S407: The second device determines the data corresponding to the Q codewords.

After receiving the Q codewords from the P transport layers, the second device decodes the Q codewords, to determine the data corresponding to the Q codewords. The first device may perform joint decoding by using an MMSE and SIC. For example, still refer to FIG. 5. The first device may determine a decoding order of the Q codewords based on a channel, or it may be considered as that the first device determines a decoding order of the P transport layers to which the Q codewords are mapped. The first device successively decodes the Q codewords in the decoding order. For each codeword, MMSE detection may be performed on the codeword before decoding to obtain an estimated sequence of the codeword, and the estimated sequence is output to a list decoder, for example, an SCL decoder. Then, the SCL decoder decodes the received estimated sequence until all codewords are decoded. As described above, the first device sends the data based on the procedure shown in FIG. 5, so that the data at the different transport layers is associated with each other. Therefore, the second device may decode the latter codeword by using the decoding result of the former codeword, to increase the decoding gain. It should be noted that a type of the list decoder is not limited in this embodiment of this application. For example, the list decoder may alternatively be a belief propagation (belief propagation, BP) list decoder, or another type of list decoder.

In an implementable, for an $i^{th}$ codeword in the Q codewords, the second device outputs L first estimated sequences corresponding to the $i^{th}$ codeword to a transport layer corresponding to an $(i+1)^{th}$ codeword. L1 is less than or equal to a list dimension of the list decoder, where i=1, 2, ..., Q-1, or i=0, 1, ..., Q-2. The list decoder may be the SCL decoder. For the $(i+1)^{th}$ codeword in the Q codewords, the second device separately performs SIC detection on L1 first estimated sequences to obtain L1 second estimated sequences, and decodes the L1 second estimated sequences to obtain L1 third estimated sequences. The second device determines, based on the L1 third estimated sequences and the first MCS index, the data corresponding to the Q codewords.

For ease of understanding, still refer to FIG. 5, which shows the decoding process of the second device. FIG. 5 uses Q=2 and P=2 as an example. For example, the two transport layers in FIG. 5 include the first layer and the second layer, and the decoding order indicates to first decode the first codeword, and then decode the second codeword. The first codeword is transmitted through the first layer, and the second codeword is transmitted through the second layer.

The second device performs MMSE estimation on a data symbol transmitted at the first layer, and sends an estimated sequence obtained through the MMSE estimation to the SCL decoder for decoding. It may be understood that the SCL decoder generates L decoding paths, or it may be understood as that the SCL decoder may obtain the L estimated sequences (for example, referred to as the first estimated sequences) through the decoding. It should be understood that L is the list dimension of the SCL decoder. L=8 is used as an example. The SCL decoder first generates one first estimated sequence after receiving the estimated sequence obtained through the MMSE estimation, generates two first estimated sequences based on the first estimated sequence, and separately generates two first estimated sequences based on each of the two first estimated sequences, that is, generates four first estimated sequences. By analogy, L=8, and the SCL decoder may generate eight first estimated sequences.

In this embodiment of this application, an SCL decoder of the first layer may output L1 first estimated sequences in the L first estimated sequences to the second layer, where L1 is less than or equal to L. A decoding process of the second layer is similar to a decoding process of the first layer. To be specific, the second layer separately detects each of the received L1 first estimated sequences by using an MMSE-SIC detector, to obtain L1 second estimated sequences. The L1 second estimated sequences may be decoded by using one or more SCL decoders, to obtain L2 third estimated sequences. The second device determines, based on the L2 third estimated sequences and the first MCS index, the data corresponding to the Q codewords. Because the L1 first estimated sequences of the first layer are output to the second layer, incorrect transmission can be reduced. It may be understood that, after receiving the L1 first estimated sequences output by the first layer, the second layer re-modulates the L1 first estimated sequences into modulation symbol sequences corresponding to the first layer, to obtain L1 modulation symbol sequences. Then, the L1 modulation symbol sequences are deleted from an original received symbol sequence, that is, impact on data at a next layer is eliminated, and L1 second estimated sequences after impact of the first layer is eliminated are obtained. The second layer decodes the L1 second estimated sequences by using the one or more SCL decoders, to obtain the L2 third estimated sequences.

The second layer may decode the received L1 second estimated sequences by using the one or more SCL decoders, to obtain the L2 third estimated sequences. For ease of description, an SCL decoder corresponding to the former codeword is referred to as a first SCL decoder below, and an SCL decoder corresponding to the latter codeword is referred to as a second SCL decoder below.

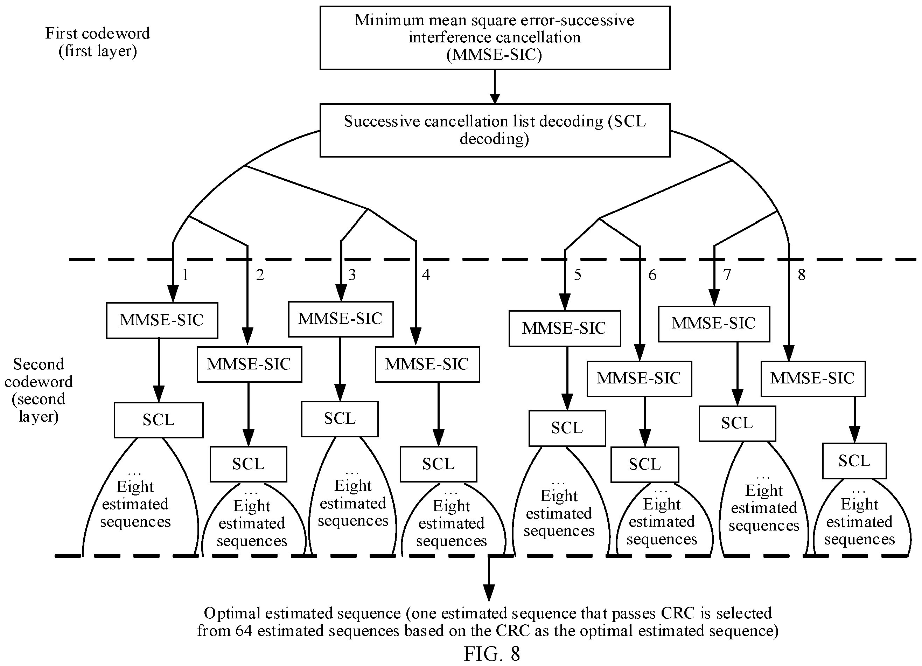

For example, FIG. 8 is a diagram of performing decoding by the second layer by using a plurality of second SCL decoders. FIG. 8 uses L1=L=8 as an example. The first layer outputs the L1 first estimated sequences to the second layer. The second layer detects the L1 first estimated sequences respectively by using L1 MMSE-SIC detectors, where one MMSE-SIC detector corresponds to one first estimated sequence. Then, the second layer decodes the L1 second estimated sequences respectively by using L1 second SCL decoders, to obtain the L2 third estimated sequences, where one second SCL decoder corresponds to one second estimated sequence. It may be understood that L2=L1×L1. As shown in FIG. 8, L1=8, and L2=64. The second layer selects, from the L2 third estimated sequences based on the CRC, a third estimated sequence that passes the CRC as an optimal estimated sequence of a codeword at the second layer, that is, an optimal decoding result. As shown in FIG. 8, it may also be considered that an estimated sequence of a first SCL decoder of the former codeword is used as an input of a second SCL decoder of the latter codeword. One estimated sequence output by the first SCL decoder of the former codeword is used as an input of one second SCL decoder of the latter codeword. For example, the first SCL decoder of the former codeword outputs L1 first estimated sequences, and the L1 first estimated sequences are in one-to-one correspondence with L1 second SCL decoders of the latter codeword. The first estimated sequences input by all the second SCL decoders are the same. It should be noted that if the L2 third estimated sequences do not pass the CRC, an estimated sequence corresponding to a large accumulated metric value of a path in the L2 third estimated sequences may be selected as the optimal estimated sequence.

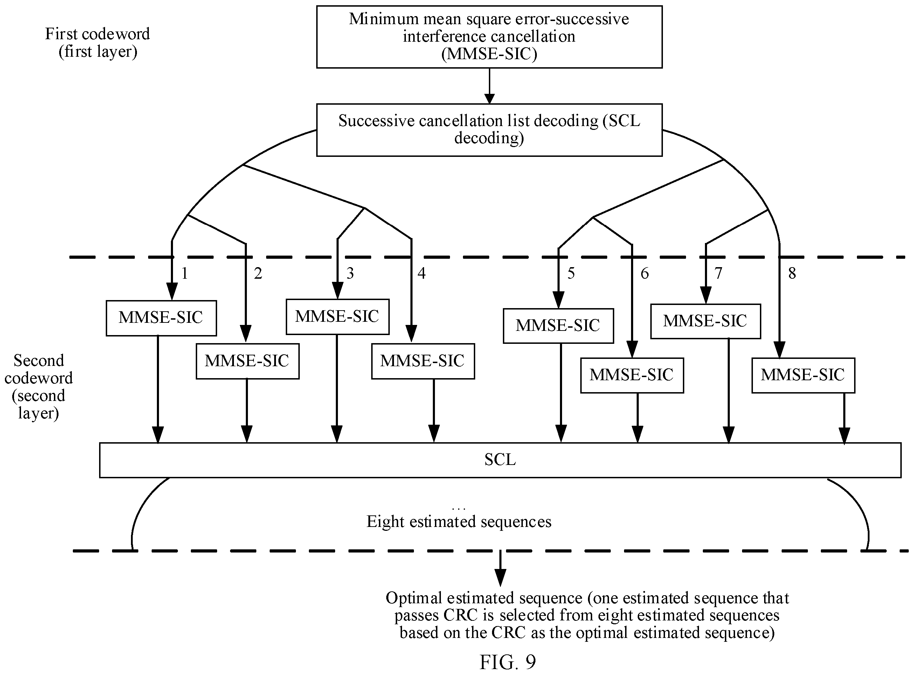

For example, FIG. 9 is a diagram of performing decoding by the second layer by using one SCL decoder. Difference from FIG. 8, the second layer performs decoding by using one second SCL decoder. That is, the first layer outputs the L1 first estimated sequences to the second layer. The second layer detects the L1 first estimated sequences respectively by using L1 MMSE-SIC detectors, where one MMSE-SIC detector corresponds to one first estimated sequence. Then, the second layer decodes the L1 second estimated sequences by using one second SCL decoder, to obtain the L2 third estimated sequences, where the one second SCL decoder corresponds to the L1 second estimated sequence. It may be understood that L2=L1. As shown in FIG. 9, L1=8, and L2=8. The second layer selects, from the L2 third estimated sequences based on the CRC, a third estimated sequence that passes the CRC as an optimal estimated sequence of a codeword at the second layer, that is, an optimal decoding result. As shown in FIG. 9, it may also be considered that an estimated sequence of a first SCL decoder of the former codeword is used as an input of a second SCL decoder of the latter codeword. L1 estimated sequence output by the first SCL decoder of the former codeword is used as the input of the second SCL decoder of the latter codeword. In this case, a path metric value of the second SCL decoder may inherit a path metric value of the first SCL decoder. The second SCL decoder and the first SCL decoder may be considered as a global SCL decoder, and the SCL decoder outputs only L estimated sequences. A quantity of estimated sequences does not increase with increase of a quantity of layers, to reduce decoding complexity as much as possible. It should be noted that if the L2 third estimated sequences do not pass the CRC, an estimated sequence corresponding to a large accumulated metric value of a path in the L2 third estimated sequences may be selected as the optimal estimated sequence.

In this embodiment of this application, the first device (transmit end) first checks the original bit sequence based on the CRC code, and then performs code rate allocation, to couple the data at the different transport layers (codewords) by using the CRC, so that the data at the different transport layers (codewords) is associated. For the second device (receive end), in the decoding process, the decoding result of the former codeword may be used to decode the latter codeword. For example, in the decoding process, the second device may reserve a plurality of decoding results (estimated sequences) of the $i^{th}$ codeword, to decode the $(i+1)^{th}$ codeword, so that incorrect transmission caused by an error in the estimated sequence can be reduced as much as possible, to increase the decoding gain of the receive end. In addition, association may be established between data of a plurality of codewords by using one CRC code. That is, joint decoding is established for the plurality of codewords. In this way, during decoding, check on the data of the plurality of codewords can be completed by using one CRC. In other words, one optimal estimated sequence is selected from a plurality of estimated sequences to complete decoding, to reduce CRC overheads and a code rate loss.

In embodiments provided in this application, the methods provided in embodiments of this application are described separately from perspectives of the first device, the second device, and interaction between the first device and the second device. To implement functions in the methods provided in the foregoing embodiments of this application, the first device and the second device may include a hardware structure and/or a software module, and implement the foregoing functions in a form of the hardware structure, the software module, or a combination of the hardware structure and the software module. Whether a function in the foregoing functions is performed by the hardware structure, the software module, or the combination of the hardware structure and the software module depends on particular applications and design constraints of the technical solutions.

The following describes a communication apparatus for implementing the foregoing methods in embodiments of this application with reference to the accompanying drawings.

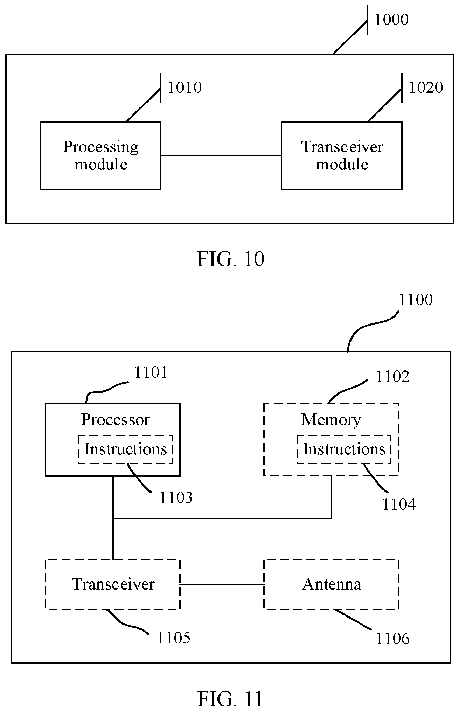

FIG. 10 is a block diagram of a communication apparatus 1000 according to an embodiment of this application. The communication apparatus 1000 may include a processing module 1010 and a transceiver module 1020. Optionally, a storage unit may be further included. The storage unit may be configured to store instructions (code or a program) and/or data. The processing module 1010 and the transceiver module 1020 may be coupled to the storage unit. For example, the processing module 1010 may read the instructions (code or program) and/or data in the storage unit, to implement a corresponding method. The foregoing modules may be independently disposed, or may be partially or completely integrated.

In some possible implementations, the communication apparatus 1000 can correspondingly implement behavior and functions of the first device in the foregoing method embodiments. The communication apparatus 1000 may be the first device, may be a component (for example, a chip or a circuit) used in the first device, or may be a chip or a chip set in the first device, or a part that is of the chip and that is configured to perform a related method function.

For example, the communication apparatus 1000 implements the method performed by the first device in embodiments of this application. The transceiver module 1020 may be configured to receive first information. The processing module 1010 is configured to: check a first bit sequence based on a CRC code to obtain a second bit sequence, divide the second bit sequence into P bit sequences, and generate Q codewords based on the P bit sequences, where P is a quantity of transport layers of the communication apparatus 1000, P is greater than or equal to 2, and Q is an integer greater than or equal to 2. The transceiver module 1020 is configured to send the Q codewords to a second device through the P transport layers.

In an optional implementation, the transceiver module 1020 is further configured to send a first MCS index to the second device, where the first MCS index indicates code rates and modulation orders that respectively correspond to the Q codewords.

In an optional implementation, that the first MCS index indicates code rates and modulation orders that respectively correspond to the Q codewords includes: The first MCS index corresponds to Q sub-indexes, where the Q sub-indexes are in one-to-one correspondence with the Q codewords, and one of the Q sub-indexes corresponds to one group of a code rate and a modulation order.

In an optional implementation, the transceiver module 1020 is further configured to receive indication information sent by the second device, where the indication information indicates whether the second device uses a first receiving mode.

In an optional implementation, the processing module 1010 is further configured to determine the first MCS index based on the indication information.

In an optional implementation, Q is equal to P, and the Q codewords are one-to-one mapped to the P transport layers; or Q is less than P, and one of the Q codewords is mapped to one or two layers in the P transport layers.

In an optional implementation, the processing module 1010 is specifically configured to divide the second bit sequence into the P bit sequences based on a capacity of each of the P transport layers, where transport layers with different capacities correspond to different lengths of bit sequences.

In an optional implementation, a capacity of a $k^{th}$ transport layer in the P transport layers is based on transmit power, interference power, and noise power of the $k^{th}$ transport layer.

In an optional implementation, the capacity $C_k$ of the $k^{th}$ transport layer in the P transport layers satisfies the following formula:

$$C_k = \log\left(1 + P_k \boldsymbol{h}_k^* \left(N_0 \boldsymbol{I}_{N_r} + \sum_{i=k+1}^{N_t} P_i \boldsymbol{h}_k \boldsymbol{h}_k^*\right)^{-1} \boldsymbol{h}_k\right),$$

where

k=1, 2, ..., P, $P_k$ is transmit power of each antenna of the communication apparatus 1000, $N_0$ is noise power, $\boldsymbol{h_k}$ is a $k^{th}$ column for a channel H, $N_r$ is a quantity of receive antennas, $N_t$ is a quantity of transmit antennas, $\boldsymbol{h_k}$ is the $k^{th}$ column for the

channel H, and $\boldsymbol{h}_k^*$ is a conjugate transpose of $h_k$.

For another example, the communication apparatus 1000 implements the method performed by the second device in any embodiment of this application. The transceiver module 1020 is configured to: receive, from P transport layers, Q codewords sent by a first device, and receive a first MCS index sent by the first device. P is an integer greater than or equal to 2, Q is an integer greater than or equal to 2, and the first MCS index indicates code rates and modulation orders that respectively correspond to the Q codewords. The processing module 1010 is configured to determine, based on the first MCS index, the code rates and the modulation orders that respectively correspond to the Q codewords.

In an optional implementation, the processing module 1010 is further configured to:

for an $i^{th}$ codeword in the Q codewords, output L1 first estimated sequences corresponding to the $i^{th}$ codeword to a transport layer corresponding to an $(i+1)^{th}$ codeword, where L1 is less than or equal to a list dimension L of a list decoder, and i=1, 2, ..., Q-1; and

for the $(i+1)^{th}$ codeword in the Q codewords, separately perform SIC detection on the L1 first estimated sequences to obtain L1 second estimated sequences, and decode the L2 second estimated sequences to obtain L2 third estimated sequences, where L2 is greater than or equal to L1.

In an optional implementation, that the first MCS index indicates code rates and modulation orders that correspond to the Q codewords includes: The first MCS index corresponds to Q sub-indexes, where the Q sub-indexes are in one-to-one correspondence with the Q codewords, and one of the Q sub-indexes corresponds to one group of a code rate and a modulation order.

In an optional implementation, the transceiver module 1020 is further configured to send indication information to the first device, where the indication information indicates whether the second device uses a first receiving mode.

In an optional implementation, Q is equal to P, and the Q codewords are one-to-one mapped to the P transport layers; or Q is less than P, and one of the Q codewords is mapped to one or two layers in the P transport layers.

It should be understood that, in this embodiment of this application, the processing module 1010 may be implemented as a processor or a processor-related circuit component, and the transceiver module 1020 may be implemented as a transceiver or a transceiver-related circuit component or a communication interface.

FIG. 11 is a block diagram of a communication apparatus 1100 according to an embodiment of this application. The communication apparatus 1100 may be a first device, and can implement functions of the first device in the methods provided in embodiments of this application. The communication apparatus 1100 may alternatively be an apparatus that can support the first device in implementing a corresponding function in the methods provided in embodiments of this application. The communication apparatus 1100 may be a chip system. In this embodiment of this application, the chip system may include a chip, or may include a chip and another discrete component. For a specific function, reference may be made to the descriptions in the foregoing method embodiments. The communication apparatus 1100 may alternatively be a second device, and can implement functions of the second device in the methods provided in embodiments of this application. The communication apparatus 1100 may alternatively be an apparatus that can support the second device in implementing a corresponding function in the methods provided in embodiments of this application. The communication apparatus 1100 may be a chip system. In this embodiment of this application, the chip system may include a chip, or may include a chip and another discrete component. For a specific function, reference may be made to the descriptions in the foregoing method embodiments.

The communication apparatus 1100 includes one or more processors 1101 that may be configured to implement or support the communication apparatus 1100 in implementing the functions of the first device in the methods provided in embodiments of this application. For details, refer to the detailed descriptions in the method examples. Details are not described herein again. The one or more processors 1101 may alternatively be configured to implement or support the communication apparatus 1100 in implementing the functions of the second device in the methods provided in embodiments of this application. For details, refer to the detailed descriptions in the method examples. Details are not described herein again. The processor 1101 may also be referred to as a processing unit or a processing module, and may implement a specific control function. The processor 1101 may be a general-purpose processor, a dedicated processor, or the like. For example, the processor 1101 includes: a central processing unit, an application processor, a modem processor, a graphics processing unit, an image signal processor, a digital signal processor, a video codec processor, a controller, a memory, and/or a neural-network processing unit. The central processing unit may be configured to control the communication apparatus 1100, execute a software program, and/or process data. Different processors may be independent components, or may be integrated into one or more processors, for example, integrated into one or more application-specific integrated circuits.

Optionally, the communication apparatus 1100 includes one or more memories 1102, configured to store instructions 1104. The instructions may be run on the processor 1101, to enable the communication apparatus 1100 to perform the methods described in the foregoing method embodiments. The memory 1102 and the processor 1101 may be separately disposed, or may be integrated together, or it may be considered that the memory 1102 is coupled to the processor 1101. The coupling in this embodiment of this application may be an indirect coupling or a communication connection between apparatuses, units, or modules in an electrical form, a mechanical form, or another form, and is used for information exchange between the apparatuses, the units, or the modules. The processor 1101 may operate in collaboration with the memory 1102. At least one of the at least one memory may be included in the processor. It should be noted that the memory 1102 is not necessary, and therefore is shown by using dashed lines in FIG. 11.

Optionally, the memory 1102 may further store data. The processor and the memory may be separately disposed, or may be integrated together. In this embodiment of this application, the memory 1102 may be a nonvolatile memory, such as a hard disk drive (hard disk drive, HDD) or a solid-state drive (solid-state drive, SSD), or may be a volatile memory (volatile memory), such as a random access memory (random access memory, RAM). The memory is any other medium that can carry or store expected program code in a form of an instruction structure or a data structure and that can be accessed by a computer, but is not limited thereto. The memory in this embodiment of this application may alternatively be a circuit or any other apparatus that can implement a storage function, and is configured to store program instructions and/or data.

Optionally, the communication apparatus 1100 may include instructions 1103 (which may also be referred to as code or a program sometimes), and the instructions 1103 may be run on the processor, to enable the communication apparatus 1100 to perform the methods described in the foregoing embodiments. The processor 1101 may store data.

Optionally, the communication apparatus 1100 may further include a transceiver 1105 and an antenna 1106. The transceiver 1105 may be referred to as a transceiver unit, a transceiver module, a transceiver machine, a transceiver circuit, a transceiver, an input/output interface, or the like, and is configured to implement a transceiver function of the communication apparatus 1100 through the antenna 1106.

The processor 1101 and the transceiver 1105 described in this application may be implemented in an integrated circuit (integrated circuit, IC), an analog IC, a radio frequency integrated circuit (radio frequency identification, RFID), a hybrid signal IC, an ASIC, a printed circuit board (printed circuit board, PCB), an electronic device, or the like. The communication apparatus described in this specification may be an independent device (for example, an independent integrated circuit or a mobile phone), or may be a part of a large device (for example, a module that may be embedded in another device). For details, refer to the foregoing descriptions about the terminal device and the network device. Details are not described herein again.

Optionally, the communication apparatus 1100 may further include one or more of the following components: a wireless communication module, an audio module, an external memory interface, an internal memory, a universal serial bus (universal serial bus, USB) interface, a power management module, an antenna, a speaker, a microphone, an input/output module, a sensor module, a motor, a camera, a display, or the like. It may be understood that in some embodiments, the communication apparatus 1100 may include more or fewer components, or some components are integrated, or some components are split. These components may be hardware, software, or a combination implementation of software and hardware.

It should be noted that the communication apparatus in the foregoing embodiments may be the first device (or the second device), may be a circuit, may be a chip used in the first device (or the second device), or may be another combined device, component, or the like that has functions of the first device (or the second device). When the communication apparatus is the first device (or the second device), the transceiver module may be a transceiver, and may include an antenna, a radio frequency circuit, and the like. The processing module may be a processor, for example, a central processing unit (central processing unit, CPU). When the communication apparatus is a component that has the functions of the first device (or the second device), the transceiver module may be a radio frequency unit, and the processing module may be a processor. When the communication apparatus is a chip system, the communication apparatus may be a field programmable gate array (field programmable gate array, FPGA), an application-specific integrated circuit (application-specific integrated circuit, ASIC), a system on chip (system on chip, SoC), a CPU, a network processor (network processor, NP), a digital signal processing circuit (digital signal processor, DSP), a micro controller unit (micro controller unit, MCU), a programmable controller (programmable logic device, PLD), or another integrated chip. The processing module may be a processor of the chip system. The transceiver module or the communication interface may be an input/output interface or an interface circuit of the chip system. For example, the interface circuit may be a code/data read/write interface circuit. The interface circuit may be configured to receive code instructions (the code instructions are stored in the memory and may be directly read from the memory, or may be read from the memory through another component) and transmit the code instructions to the processor. The processor may be configured to run the code instructions to perform the methods in the foregoing method embodiments. For another example, the interface circuit may alternatively be a signal transmission interface circuit between a communication processor and the transceiver machine.

When the communication apparatus is a chip apparatus or circuit, the apparatus may include a transceiver unit and a processing unit. The transceiver unit may be an input/output circuit and/or a communication interface. The processing unit is an integrated processor, a microprocessor, or an integrated circuit.

An embodiment of this application further provides a communication system. Specifically, the communication system includes at least one first device and at least one second device. For example, the communication system includes the first device and the second device that are configured to implement the related functions in FIG. 4. For details, refer to the related descriptions in the foregoing method embodiments. Details are not described herein again.

An embodiment of this application further provides a computer-readable storage medium, including instructions. When the instructions are run on a computer, the computer is enabled to perform the method performed by the second device in FIG. 4. Alternatively, when the instructions are run on a computer, the computer is enabled to perform the method performed by the first device in FIG. 4.

An embodiment of this application further provides a computer program product, including instructions. When the instructions are run on a computer, the computer is enabled to perform the method performed by the second device in FIG. 4. Alternatively, when the instructions are run on a computer, the computer is enabled to perform the method performed by the first device in FIG. 4.

An embodiment of this application provides a chip system. The chip system includes a processor, and may further include a memory, configured to implement the functions of the second device in the foregoing methods, or configured to implement the functions of the first device in the foregoing methods. The chip system may include a chip, or may include a chip and another discrete component.

It should be understood that sequence numbers of the foregoing processes do not mean execution sequences in various embodiments of this application. The execution sequences of the processes should be determined based on functions and internal logic of the processes, and should not be construed as any limitation on the implementation processes of embodiments of this application.

A person of ordinary skill in the art may be aware that, illustrative logical blocks (illustrative logical blocks) and steps (steps) described with reference to embodiments disclosed in this specification may be implemented by electronic hardware or a combination of computer software and electronic hardware. Whether the functions are executed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for detailed a working process of the foregoing system, apparatus, and unit, refer to a corresponding process in the foregoing method embodiments. Details are not described herein again.

In several embodiments provided in this application, it should be understood that the disclosed system, apparatus, and method may be implemented in other manners. For example, the described apparatus embodiments are merely examples. For example, division into the units is merely logical function division and there may be another division manner in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic form, a mechanical form, or another form.

The units described as separate parts may or may not be physically separate, and parts displayed as units may or may not be physical units, may be located in one position, or may be distributed on a plurality of network units. Some or all of the units may be selected based on an actual requirement to achieve the objectives of the solutions of embodiments.

When the functions are implemented in a form of a software functional unit and sold or used as an independent product, the functions may be stored in a computer-readable storage medium. Based on such an understanding, a part that essentially contributes to the technical solutions of this application or a part of the technical solutions may be embodied in a form of a software product. The computer software product is stored in a storage medium, and includes several instructions for enabling a computer device (which may be a personal computer, a server, a network device, or the like) to perform all or some steps of the methods in embodiments of this application. The foregoing storage medium includes any medium, for example, a USB flash drive, a removable hard disk, a read-only memory (read-only memory, ROM), a RAM, a magnetic disk, or an optical disc, that can store program code.

It is clear that a person skilled in the art can make various modifications and variations to this application without departing from the scope of this application. In this way, this application is intended to cover these modifications and variations of this application provided that they fall within the scope of the claims of this application and equivalent technologies thereof.

**Claims**

1. A communication method, comprising:

   checking, by a first device, a first bit sequence based on a cyclic redundancy check CRC code, to obtain a second bit sequence;
   dividing, by the first device, the second bit sequence into P bit sequences, wherein P is a quantity of transport layers of the first device, and P is greater than or equal to 2; and
   generating, by the first device, Q codewords based on the P bit sequences, and sending the Q codewords to a second device through the P transport layers, wherein Q is an integer greater than or equal to 2.

2. The method according to claim 1, wherein the method further comprises:
   sending, by the first device, a first modulation and coding scheme MCS index to the second device, wherein the first MCS index indicates code rates and modulation orders that respectively correspond to the Q codewords.

3. The method according to claim 2, wherein that the first MCS index indicates code rates and modulation orders that respectively correspond to the Q codewords comprises:
   the first MCS index corresponds to Q sub-indexes, the Q sub-indexes are in one-to-one correspondence with the Q codewords, and one of the Q sub-indexes corresponds to one group of a code rate and a modulation order.

4. The method according to any one of claims 1 to 3, wherein the method further comprises:
   receiving, by the first device, indication information sent by the second device, wherein the indication information indicates whether the second device uses a first receiving mode.

5. The method according to claim 4, wherein the method further comprises:
   determining, by the first device, the first MCS index based on the indication information.

6. The method according to any one of claims 1 to 5, wherein

   Q is equal to P, and the Q codewords are one-to-one mapped to the P transport layers; or
   Q is less than P, and one of the Q codewords is mapped to one or two layers in the P transport layers.

7. The method according to any one of claims 1 to 6, wherein the dividing, by the first device, the second bit sequence into P bit sequences comprises:
   dividing, by the first device, the second bit sequence into the P bit sequences based on a capacity of each of the P transport layers, wherein transport layers with different capacities correspond to different lengths of bit sequences.

8. The method according to claim 7, wherein a capacity of a $k^{th}$ transport layer in the P transport layers is based on transmit power, interference power, and noise power of the $k^{th}$ transport layer.

9. The method according to claim 8, wherein the capacity $C_k$ of the $k^{th}$ transport layer in the P transport layers satisfies the following formula:

$$C_k = \log\left(1 + P_k \boldsymbol{h}_k^* \left(N_0 \boldsymbol{I}_{N_r} + \sum_{i=k+1}^{N_t} P_i \boldsymbol{h}_k \boldsymbol{h}_k^*\right)^{-1} \boldsymbol{h}_k\right),$$

wherein

k=1, 2, ..., P, $P_k$ is transmit power of each antenna of the first device, No is noise power, $\mathbf{h_k}$ is a $k^{th}$ column for a channel H, $N_r$ is a quantity of receive antennas, $N_t$ is a quantity of transmit antennas, $\mathbf{h_k}$ is the $k^{th}$ column for the channel H, and

$h_k^*$ is a conjugate transpose of $h_k$.

10. A communication method, comprising:

   receiving, by a second device from P transport layers, Q codewords sent by a first device, wherein P is an integer greater than or equal to 2, and Q is an integer greater than or equal to 2; and
   receiving, by the second device, a first modulation and coding scheme MCS index sent by the first device, wherein the first MCS index indicates code rates and modulation orders that respectively correspond to the Q codewords.

11. The method according to claim 10, wherein the method further comprises:

   for an $i^{th}$ codeword in the Q codewords, outputting, by the second device, L1 first estimated sequences corresponding to the $i^{th}$ codeword to a transport layer corresponding to an $(i+1)^{th}$ codeword, wherein L1 is less than or equal to a list dimension L of a list decoder, and i=1, 2, ..., Q-1; and
   for the $(i+1)^{th}$ codeword in the Q codewords, separately performing, by the second device, successive interference cancellation SIC detection on the L1 first estimated sequences to obtain L1 second estimated sequences, and decoding the L1 second estimated sequences to obtain L2 third estimated sequences, wherein the L2 third estimated sequences are used to determine data corresponding to the Q codewords, and L2 is greater than or equal to L1.

12. The method according to claim 10 or 11, wherein that the first MCS index indicates code rates and modulation orders that correspond to the Q codewords comprises:
   the first MCS index corresponds to Q sub-indexes, the Q sub-indexes are in one-to-one correspondence with the Q codewords, and one of the Q sub-indexes corresponds to one group of a code rate and a modulation order.

13. The method according to any one of claims 10 to 12, wherein the method further comprises:
   sending, by the second device, indication information to the first device, wherein the indication information indicates whether the second device uses a first receiving mode.

14. The method according to any one of claims 10 to 13, wherein

   Q is equal to P, and the Q codewords are one-to-one mapped to the P transport layers; or
   Q is less than P, and one of the Q codewords is mapped to one or two layers in the P transport layers.

15. A communication apparatus, comprising a processing module and a transceiver module, wherein

   the processing module is configured to: check a first bit sequence based on a cyclic redundancy check CRC code to obtain a second bit sequence, divide the second bit sequence into P bit sequences, and generate Q codewords based on the P bit sequences, wherein P is a quantity of transport layers of the first device, P is greater than or equal to 2, and Q is an integer greater than or equal to 2; and
   the transceiver module is configured to send the Q codewords to a second device through the P transport layers.

16. The apparatus according to claim 15, wherein the transceiver module is further configured to:
   send a first modulation and coding scheme MCS index to the second device, wherein the first MCS index indicates code rates and modulation orders that respectively correspond to the Q codewords.

17. The apparatus according to claim 16, wherein that the first MCS index indicates code rates and modulation orders that respectively correspond to the Q codewords comprises:
   the first MCS index corresponds to Q sub-indexes, the Q sub-indexes are in one-to-one correspondence with the Q codewords, and one of the Q sub-indexes corresponds to one group of a code rate and a modulation order.

18. The apparatus according to any one of claims 15 to 17, wherein the transceiver module is further configured to:
   receive indication information sent by the second device, wherein the indication information indicates whether the second device uses a first receiving mode.

**19.** The apparatus according to claim 18, wherein the processing module is further configured to:
determine the first MCS index based on the indication information.

**20.** The apparatus according to any one of claims 15 to 19, wherein

Q is equal to P, and the Q codewords are one-to-one mapped to the P transport layers; or
Q is less than P, and one of the Q codewords is mapped to one or two layers in the P transport layers.

**21.** The apparatus according to any one of claims 15 to 20, wherein the processing module is specifically configured to:
divide the second bit sequence into the P bit sequences based on a capacity of each of the P transport layers, wherein transport layers with different capacities correspond to different lengths of bit sequences.

**22.** The apparatus according to claim 21, wherein a capacity of a $k^{th}$ transport layer in the P transport layers is based on transmit power, interference power, and noise power of the $k^{th}$ transport layer.

**23.** The apparatus according to claim 22, wherein the capacity $C_k$ of the $k^{th}$ transport layer in the P transport layers satisfies the following formula:

$$C_k = \log\left(1 + P_k \boldsymbol{h}_k^* \left(N_0 \boldsymbol{I}_{N_r} + \sum_{i=k+1}^{N_t} P_i \boldsymbol{h}_k \boldsymbol{h}_k^*\right)^{-1} \boldsymbol{h}_k\right),$$

wherein
k=1, 2, ..., P, $P_k$ is transmit power of each antenna of the first device, No is noise power, $\boldsymbol{h}_k$ is a $k^{th}$ column for a channel H, $N_r$ is a quantity of receive antennas, $N_t$ is a quantity of transmit antennas, $\boldsymbol{h}_k$ is the $k^{th}$ column for the channel H, and $\boldsymbol{h}_k^*$ is a conjugate transpose of $h_k$.

**24.** A communication apparatus, comprising a processing module and a transceiver module, wherein

the transceiver module is configured to: receive, from P transport layers, Q codewords sent by a first device, and receive a first modulation and coding scheme MCS index sent by the first device, wherein P is an integer greater than or equal to 2, Q is an integer greater than or equal to 2, and the first MCS index indicates code rates and modulation orders that respectively correspond to the Q codewords; and
the processing module is configured to determine, based on the first MCS index, the code rates and the modulation orders that respectively correspond to the Q codewords.

**25.** The apparatus according to claim 24, wherein the processing module is further configured to:

for an $i^{th}$ codeword in the Q codewords, output L1 first estimated sequences corresponding to the $i^{th}$ codeword to a transport layer corresponding to an $(i+1)^{th}$ codeword, wherein L1 is less than or equal to a list dimension L of a list decoder, and i=1, 2, ..., Q-1; and
for the $(i+1)^{th}$ codeword in the Q codewords, separately perform successive interference cancellation SIC detection on the L1 first estimated sequences to obtain L1 second estimated sequences, and decode the L1 second estimated sequences to obtain L2 third estimated sequences, wherein the L2 third estimated sequences are used to determine data corresponding to the Q codewords, and L2 is greater than or equal to L1.

**26.** The apparatus according to claim 24 or 25, wherein that the first MCS index indicates code rates and modulation orders that correspond to the Q codewords comprises:
the first MCS index corresponds to Q sub-indexes, the Q sub-indexes are in one-to-one correspondence with the Q codewords, and one of the Q sub-indexes corresponds to one group of a code rate and a modulation order.

**27.** The apparatus according to any one of claims 24 to 26, wherein the transceiver module is further configured to:
send indication information to the first device, wherein the indication information indicates whether the communication apparatus uses a first receiving mode.

**28.** The apparatus according to any one of claims 24 to 27, wherein

Q is equal to P, and the Q codewords are one-to-one mapped to the P transport layers; or

Q is less than P, and one of the Q codewords is mapped to one or two layers in the P transport layers.

29. A communication apparatus, wherein the communication apparatus comprises a processor and a memory, the memory is configured to store a computer program, and the processor is configured to execute the computer program stored in the memory, to enable the communication apparatus to perform the method according to any one of claims 1 to 9, or to enable the communication apparatus to perform the method according to any one of claims 10 to 14.

30. A computer-readable storage medium, wherein the computer-readable storage medium stores a computer program, and when the computer program is executed by a computer, the computer is enabled to perform the method according to any one of claims 1 to 9, or the computer is enabled to perform the method according to any one of claims 10 to 14.

31. A computer program product, wherein the computer program product stores a computer program, and when the computer program is executed by a computer, the computer is enabled to perform the method according to any one of claims 1 to 9, or the computer is enabled to perform the method according to any one of claims 10 to 14.

32. A communication system, comprising a first device configured to perform the method according to any one of claims 1 to 9 and a second device configured to perform the method according to any one of claims 10 to 14.

FIG. 1

**FIG. 2**

Layer mapping

$S_1^{\sim 1}, S_2^{\sim 1}, ..., S_{Ntx}^{\sim 1}$

$S_1^{\sim 2}, S_2^{\sim 2}, ..., S_{Ntx}^{\sim 2}$

$R[1,:]=r_{1,1}, ... r_{1,Mtx}$

$R[2,:]=r_{2,1}, ... r_{2,Mtx}$

Channel

Determine a decoding order of codewords (transport layers)

Minimum mean square error detection

A CA-SCL decoder decodes a current layer (k)

Is k less than a quantity of transport layers?

No → End

Yes → Eliminate interference, update the channel, and update R based on an optimal estimated sequence

---

K bit sequences

$u_1, u_2, ..., u_K$

Code rate allocation

$u_1, u_2, ..., u_{K1}$

$u_{K1+1}, u_{K1+2}, ..., u_K$

Cyclic redundancy check encoding

$u_1, u_2, ..., u_{K1+24}, p_1, p_2, ..., p_{24}$

$u_{K1+1}, u_{K1+2}, ..., u_K, r_1, r_2, ..., r_{24}$

Polar code encoding

$C^1$

$C^2$

Rate matching

$C_1^1, C_2^1, ..., C_{Ntx}^1$

$C_1^2, C_2^2, ..., C_{Ntx}^2$

Interleaving

$C_1^{\sim 1}, C_2^{\sim 1}, ..., C_{Ntx}^{\sim 1}$

$C_1^{\sim 2}, C_2^{\sim 2}, ..., C_{Ntx}^{\sim 2}$

Modulation

$S_1^{\sim 1}, S_2^{\sim 1}, ..., S_{Ntx}^{\sim 1}$

$S_1^{\sim 2}, S_2^{\sim 2}, ..., S_{Ntx}^{\sim 2}$

First
codeword
(first layer)

Minimum mean square error-
successive interference cancellation
(MMSE-SIC)

Cyclic redundancy check-aided
successive cancellation list decoding
(CA-SCL decoding)

1    2    3    4         5    6    7    8

Optimal estimated
sequence (a
quantity is 1)

Second
codeword
(second
layer)

Minimum mean square error-
successive interference cancellation
(MMSE-SIC)

Cyclic redundancy check-aided
successive cancellation list decoding
(CA-SCL decoding)

1    2    3    4         5    6    7    8

Optimal estimated
sequence (a
quantity is 1)

FIG. 3

```
┌──────────┐                                            ┌──────────┐
│  First   │                                            │  Second  │
│  device  │                                            │  device  │
└────┬─────┘                                            └────┬─────┘
┌────┴────────────────────────────┐                         │
│ S401: Check a first bit sequence │                        │
│ based on a cyclic redundancy     │                        │
│ check code to obtain a second    │                        │
│ bit sequence                     │                        │
└────┬────────────────────────────┘                         │
     │          S404: Indication information                │
     │          (indicating whether the second              │
     │          device uses a first receiving mode)         │
     │◄────────────────────────────────────────────────────┤
┌────┴────────────────────────────┐                         │
│ S402: Divide the second bit      │                        │
│ sequence into P bit sequences,   │                        │
│ where P is a quantity of         │                        │
│ transport layers of the first    │                        │
│ device                           │                        │
└────┬────────────────────────────┘                         │
┌────┴────────────────────────────┐                         │
│ S403: Generate Q codewords based │                        │
│ on the P bit sequences           │                        │
└────┬────────────────────────────┘                         │
     │    S405: First MCS index (indicating                 │
     │    modulation orders and code rates                  │
     │    that respectively corresponding to                │
     │    the Q codewords)                                  │
     ├────────────────────────────────────────────────────►│
     │      S406: Q codewords (mapped                       │
     │      to the P transport layers)                      │
     ├────────────────────────────────────────────────────►│
     │                              ┌──────────────────────┴────────┐
     │                              │ S407: Determine data          │
     │                              │ corresponding to the Q        │
     │                              │ codewords                     │
     │                              └──────────────────────┬────────┘
     │                                                      │
```

FIG. 4

$S_1^{\sim 2}, S_2^{\sim 2}, ..., S_{Ntx}^{\sim 2}$

$S_1^{\sim 1}, S_2^{\sim 1}, ..., S_{Ntx}^{\sim 1}$

Layer mapping

$R[2,:]=r_{2,1}, ...r_{2,Mtx}$

$R[1,:]=r_{1,1}, ...r_{1,Mtx}$

Channel

Determine a decoding order of codewords (transport layers)

Minimum mean square error detection

An SCL decoder decodes a current layer (k)

Is k less than a quantity of transport layers?

No

Yes

End

Eliminate interference, update the channel, and update R based on an optimal estimated sequence

FIG. 5

K bit sequences

$u_1, u_2, ..., u_K$

Cyclic redundancy check

$u_1, u_2, ..., u_{K+24}$

Code rate allocation

$u_{K1+1}, u_{K1+2}, ..., u_{K+24}$

$u_1, u_2, ..., u_{K1}$

Polar code encoding

$C^2$

$C^1$

Rate matching

$C_1^2, C_2^2, ..., C_{Ntx}^2$

$C_1^1, C_2^1, ..., C_{Ntx}^1$

Interleaving

$C_1^{\sim 2}, C_2^{\sim 2}, ..., C_{Ntx}^{\sim 2}$

$C_1^{\sim 1}, C_2^{\sim 1}, ..., C_{Ntx}^{\sim 1}$

Modulation

$S_1^{\sim 2}, S_2^{\sim 2}, ..., S_{Ntx}^{\sim 2}$

$S_1^{\sim 1}, S_2^{\sim 1}, ..., S_{Ntx}^{\sim 1}$

First
layer

Second
layer

| TB 1 | TB 1-CRC |
|------|----------|

| TB 2 | TB 2-CRC |
|------|----------|

CW 1

CW 2

FIG. 6

First layer and second layer

| TB | TB-CRC |
|----|--------|

Code rate
allocation

First
layer

Second
layer

CB 1

CB 2

CW 1

CW 2

FIG. 7

First codeword
(first layer)

```
┌─────────────────────────────────────┐
│  Minimum mean square error-successive │
│      interference cancellation        │
│            (MMSE-SIC)                 │
└─────────────────────────────────────┘
                    │
                    ▼
┌─────────────────────────────────────┐
│ Successive cancellation list decoding (SCL │
│              decoding)                │
└─────────────────────────────────────┘
```

1    2    3    4    5    6    7    8

Second
codeword
(second
layer)

```
┌──────────┐      ┌──────────┐         ┌──────────┐    ┌──────────┐
│ MMSE-SIC │      │ MMSE-SIC │         │ MMSE-SIC │    │ MMSE-SIC │
└──────────┘      └──────────┘         └──────────┘    └──────────┘
     │       ┌──────────┐   │     ┌──────────┐  │   ┌──────────┐  │  ┌──────────┐
     │       │ MMSE-SIC │   │     │ MMSE-SIC │  │   │ MMSE-SIC │  │  │ MMSE-SIC │
     │       └──────────┘   │     └──────────┘  │   └──────────┘  │  └──────────┘
     ▼            │         ▼          │        ▼         │       ▼        │
  ┌─────┐         ▼      ┌─────┐       ▼     ┌─────┐      ▼    ┌─────┐      ▼
  │ SCL │      ┌─────┐   │ SCL │    ┌─────┐  │ SCL │   ┌─────┐ │ SCL │   ┌─────┐
  └─────┘      │ SCL │   └─────┘    │ SCL │  └─────┘   │ SCL │ └─────┘   │ SCL │
               └─────┘              └─────┘            └─────┘           └─────┘
```

...
Eight
estimated
sequences

...
Eight
estimated
sequences

...
Eight
estimated
sequences

...
Eight
estimated
sequences

...
Eight
estimated
sequences

...
Eight
estimated
sequences

...
Eight
estimated
sequences

...
Eight
estimated
sequences

Optimal estimated sequence (one estimated sequence that passes CRC is selected
from 64 estimated sequences based on the CRC as the optimal estimated sequence)

FIG. 8

First codeword
(first layer)

```
┌─────────────────────────────────┐
│  Minimum mean square error-      │
│  successive interference         │
│  cancellation                    │
│  (MMSE-SIC)                       │
└─────────────────────────────────┘
              │
              ▼
┌─────────────────────────────────┐
│  Successive cancellation list    │
│  decoding (SCL decoding)         │
└─────────────────────────────────┘
```

1  2  3  4  5  6  7  8

Second
codeword
(second
layer)

| MMSE-SIC | | MMSE-SIC | | MMSE-SIC | | MMSE-SIC |

| MMSE-SIC | MMSE-SIC | MMSE-SIC | MMSE-SIC |

SCL

...
Eight estimated sequences

Optimal estimated sequence (one estimated sequence that
passes CRC is selected from eight estimated sequences
based on the CRC as the optimal estimated sequence)

FIG. 9

1000

Processing module

1010

Transceiver module

1020

FIG. 10

1100

1101

Processor

Instructions

1103

1102

Memory

Instructions

1104

Transceiver

1105

Antenna

1106

FIG. 11

## INTERNATIONAL SEARCH REPORT

| International application No. |
| --- |
| **PCT/CN2023/091496** |

**A.    CLASSIFICATION OF SUBJECT MATTER**

H04L1/00(2006.01)i

According to International Patent Classification (IPC) or to both national classification and IPC

**B.    FIELDS SEARCHED**

Minimum documentation searched (classification system followed by classification symbols)

IPC：H04L H04W

Documentation searched other than minimum documentation to the extent that such documents are included in the fields searched

Electronic data base consulted during the international search (name of data base and, where practicable, search terms used)

CNABS; CNTXT; CNKI; VEN; USTXT; WOTXT; EPTXT; 3GPP: 华为, 多输入多输出, 多入多出, 传输层, MIMO层, 码字, 循环冗余, 比特序列, 位序列, 映射, 极性编码, MIMO, transport+, transmission, layer?, codeword?, CW?, CRC, cyclic W redundancy, bit W sequence, map+, polar W cod+

**C.    DOCUMENTS CONSIDERED TO BE RELEVANT**

| Category* | Citation of document, with indication, where appropriate, of the relevant passages | Relevant to claim No. |
| --- | --- | --- |
| Y | US 2010239035 A1 (FUTUREWEI TECHNOLOGIES, INC.) 23 September 2010 (2010-09-23)<br>claims 1-13, and description, paragraphs 29-94 | 1-6, 10-20, 24-32 |
| Y | CN 112042139 A (SAMSUNG ELECTRONICS CO., LTD.) 04 December 2020 (2020-12-04)<br>description, paragraphs 112-285 | 1-6, 10-20, 24-32 |
| A | CN 103580788 A (CHINA ACADEMY OF TELECOMMUNICATIONS TECHNOLOGY) 12 February 2014 (2014-02-12)<br>entire document | 1-32 |
| A | CN 109525362 A (HUAWEI TECHNOLOGIES CO., LTD.) 26 March 2019 (2019-03-26)<br>entire document | 1-32 |
| A | CN 104380642 A (TELEFONAKTIEBOLAGET LM ERICSSON (PUBL)) 25 February 2015 (2015-02-25)<br>entire document | 1-32 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **03 July 2023** | **22 July 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/091496** |

### C. DOCUMENTS CONSIDERED TO BE RELEVANT

| Category* | Citation of document, with indication, where appropriate, of the relevant passages | Relevant to claim No. |
| --- | --- | --- |
| A | WO 2022083876 A1 (HUAWEI TECHNOLOGIES CO., LTD. et al.) 28 April 2022 (2022-04-28)<br>    entire document | 1-32 |

Form PCT/ISA/210 (second sheet) (July 2022)

INTERNATIONAL SEARCH REPORT
Information on patent family members

International application No.

**PCT/CN2023/091496**

| Patent document cited in search report | | | Publication date (day/month/year) | Patent family member(s) | | | Publication date (day/month/year) |
|---|---|---|---|---|---|---|---|
| US | 2010239035 | A1 | 23 September 2010 | WO | 2010105564 | A1 | 23 September 2010 |
| | | | | US | 8737503 | B2 | 27 May 2014 |
| CN | 112042139 | A | 04 December 2020 | None | | | |
| CN | 103580788 | A | 12 February 2014 | None | | | |
| CN | 109525362 | A | 26 March 2019 | None | | | |
| CN | 104380642 | A | 25 February 2015 | None | | | |
| WO | 2022083876 | A1 | 28 April 2022 | None | | | |

Form PCT/ISA/210 (patent family annex) (July 2022)

**EP 4 513 796 A1**

**Patent documents cited in the description**

- CN 202210574966